# EUROPEAN PATENT APPLICATION

(11) **EP 3 489 276 A1**
(43) Date of publication of application: **29.05.2019**
(21) Application number: 17834141.8
(22) Date of filing: 20.07.2017
(51) Int. Cl.: C08G 61/12, H01L 51/50, H05B 33/02

(54) **ORGANIC ELECTRONIC MATERIAL AND USE OF SAME**

(30) Priority: 25.07.2016 JP 2016145263; 07.11.2016 JP 2016217367
(71) Applicant: Hitachi Chemical Co., Ltd., Chiyoda-ku Tokyo 100-6606 (JP)
(72) Inventor: YOSHINARI Yuki, Tokyo 100-6606 (JP); ISHITSUKA Kenichi, Tokyo 100-6606 (JP); SUGIOKA Tomotsugu, Tokyo 100-6606 (JP); HONNA Ryo, Tokyo 100-6606 (JP); RYUZAKI Daisuke, Tokyo 100-6606 (JP); FUNYUU Shigeaki, Tokyo 100-6606 (JP)
(74) Representative: Beckmann, Claus
(86) International application number: PCT/JP2017/026222
(87) International publication number: WO 2018/021133

(57) **Abstract**

An organic electronic material including a charge transport polymer that includes any one of the structures represented by formulas (1) to (3) or formulas (1a) to (3a) is provided. X: (substituted) oxetanyl or (substituted) vinyl; n: from 1 to 12; Xa: a polymerizable functional group; m: from 1 to 30.

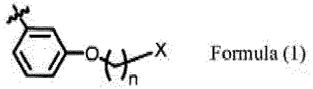

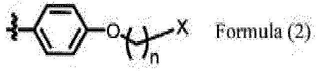

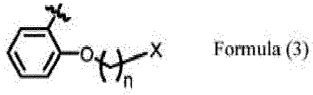

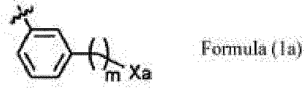

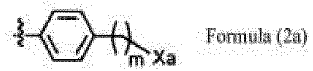

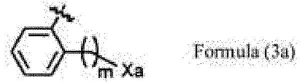

## Description

### TECHNICAL FIELD

Embodiments of the present invention relate to an organic electronic material, an organic layer, an organic electronic element, an organic electroluminescent element (also referred to as an "organic EL element"), a display element, an illumination device and a display device.

### BACKGROUND ART

Organic EL elements are attracting attention for potential use in large-surface area solid state lighting source applications to replace incandescent lamps or gas-filled lamps or the like. Further, organic EL elements are also attracting attention as the leading self-luminous display for replacing liquid crystal displays (LCD) in the field of flat panel displays (FPD), and commercial products are becoming increasingly available.

Depending on the organic material used, organic EL elements can be broadly classified into two types, namely low-molecular weight organic EL elements that use a low-molecular weight compound, and polymeric organic EL elements that use a polymer compound. The production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays (for example, see Patent Literature 1).

### CITATION LIST

### PATENT LITERATURE

Patent Literature 1: JP 2006-279007 A

### SUMMARY OF INVENTION

### TECHNICAL PROBLEM

Generally, organic EL elements produced by wet processes using polymer materials have the advantages that cost reductions and surface area increases can be achieved with relative ease. Accordingly, in recent years, various investigations have been conducted into improving various characteristics of organic EL elements by multilayering organic layers produced using polymer materials, and separating the functions of the individual layers. However, organic EL elements having organic layers produced using conventional polymer materials still require further improvements in terms of characteristics including the drive voltage, the emission efficiency and the emission lifespan.

Embodiments of the present invention have been developed in light of the above circumstances, and have an object of providing an organic electronic material that can be used favorably in organic EL elements. Other embodiments of the present invention have an object of providing an organic layer, an organic electronic element, an organic EL element, a display element, an illumination device and a display device that are formed using the above organic electronic material.

### SOLUTION TO PROBLEM

Embodiments of the present invention relates to an organic electronic material, and one embodiment of the organic electronic material relates to an organic electronic material including a charge transport polymer that includes at least one structure selected from the group consisting of a structure represented by the following formula (1), a structure represented by the following formula (2) and a structure represented by the following formula (3).

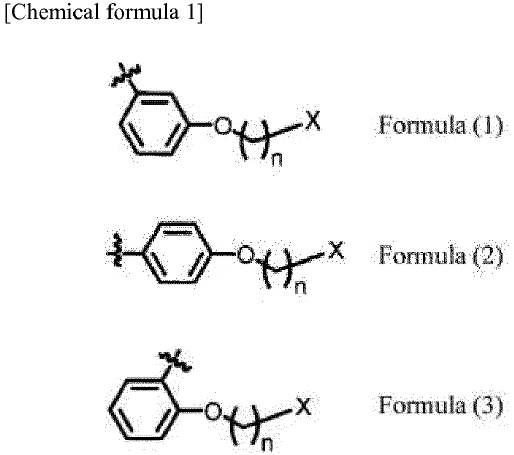

In formulas (1) to (3), X represents a polymerizable functional group selected from the group consisting of a substituted or unsubstituted oxetane group and a substituted or unsubstituted vinyl group, and n represents an integer of 1 to 12.

Another embodiment of the organic electronic material according to embodiments of the present invention relates to an organic electronic material including a charge transport polymer that includes at least one structure selected from the group consisting of a structure represented by the following formula (1a), a structure represented by the following formula (2a) and a structure represented by the following formula (3a).

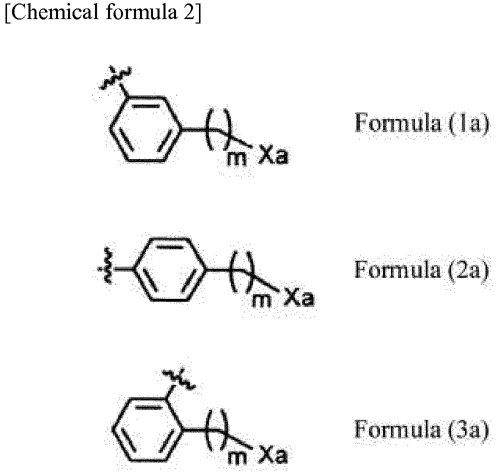

In formulas (1a) to (3a), Xa represents a polymerizable functional group, and m represents an integer of 1 to 30.

Another embodiment of the present invention relates to an organic layer formed using either of the organic electronic materials described above.

Another embodiment of the present invention relates to an organic electronic element including the organic layer described above.

Another embodiment of the present invention relates to an organic electroluminescent element including the organic layer described above.

Another embodiment of the present invention relates to a display element including the organic electroluminescent element described above.

Another embodiment of the present invention relates to an illumination device including the organic electroluminescent element described above.

Another embodiment of the present invention relates to a display device including the illumination device described above, and a liquid crystal element as a display unit.

### ADVANTAGEOUS EFFECTS OF THE INVENTION

According to embodiments of the present invention, it is possible to provide an organic electronic material that can be used favorably in organic electronic elements. It is also possible to provide an organic layer, an organic electronic element and an organic EL element that use the organic electronic material, and a display element, an illumination device and a display device that use the organic EL element.

### BRIEF DESCRIPTION OF DRAWINGS

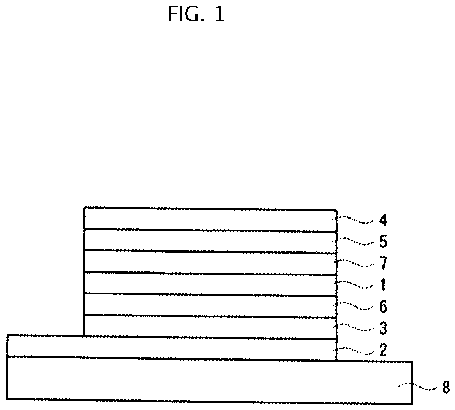

FIG. 1 is a cross-sectional schematic view illustrating one example of an organic EL element of one embodiment of the present invention.

### DESCRIPTION OF EMBODIMENTS

Embodiments of the present invention are described below, but the present invention is in no way limited by these embodiments.

In the following description, an aryl group is an atom grouping in which one hydrogen atom has been removed from an aromatic hydrocarbon. A heteroaryl group is an atom grouping in which one hydrogen atom has been removed from an aromatic heterocycle. An arylene group is an atom grouping in which two hydrogen atoms have been removed from an aromatic hydrocarbon. A heteroarylene group is an atom grouping in which two hydrogen atoms have been removed from an aromatic heterocycle. An arenetriyl group is an atom grouping in which three hydrogen atoms have been removed from an aromatic hydrocarbon. A heteroarenetriyl group is an atom grouping in which three hydrogen atoms have been removed from an aromatic heterocycle.

Examples of the aromatic hydrocarbon include monocyclic compounds, condensed ring compounds, and polycyclic compounds in which two or more selected from among monocycles and condensed rings are bonded together via a single bond (single bonds). Examples of the aromatic heterocycles include monocyclic compounds, condensed ring compounds, and polycyclic compounds in which two or more selected from among monocycles and condensed rings are bonded together via a single bond (single bonds).

### <Organic Electronic Material>

One embodiment of the organic electronic material according to embodiments of the present invention is an organic electronic material (hereafter sometimes referred to as the organic electronic material II) including a charge transport polymer (hereafter sometimes referred to as the charge transport polymer I) that includes at least one structure selected from the group consisting of a structure represented by the following formula (1), a structure represented by the following formula (2) and a structure represented by the following formula (3).

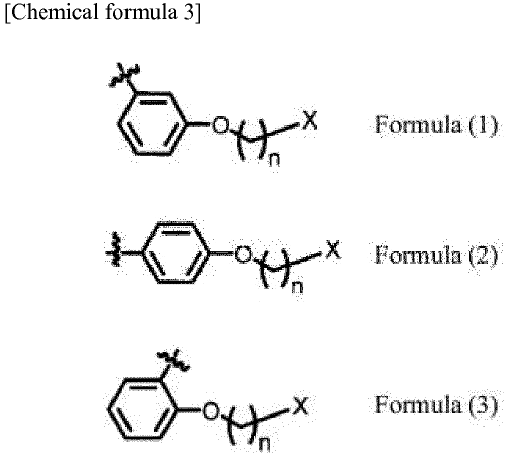

In formulas (1) to (3), X represents a polymerizable functional group selected from the group consisting of a substituted or unsubstituted oxetane group and a substituted or unsubstituted vinyl group, and n represents an integer of 1 to 12. Hereafter, X is sometimes referred to as the "polymerizable functional group X".

Another embodiment of the organic electronic material according to embodiments of the present invention is an organic electronic material (hereafter sometimes referred to as the organic electronic material II) including a charge transport polymer (hereafter sometimes referred to as the charge transport polymer II) that includes at least one structure selected from the group consisting of a structure represented by the following formula (1a), a structure represented by the following formula (2a) and a structure represented by the following formula (3a).

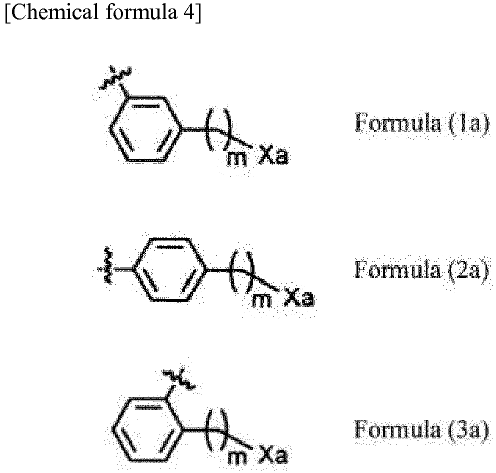

In formulas (1a) to (3a), Xa represents a polymerizable functional group, and m represents an integer of 1 to 30. Hereafter, Xa is sometimes referred to as the "polymerizable functional group Xa".

The organic electronic material I of one embodiment can be used favorably in organic electronic elements. Further, the organic electronic material I of this embodiment is suitable for use in ink compositions for wet processes.

Surprisingly, by using the organic electronic material I of this embodiment, effects including an improvement in the emission characteristics of organic EL elements, an improvement in the emission efficiency, and an improvement in the emission lifespan can be obtained. Although conjecture, it is thought that in the charge transport polymer I, by linking the polymerizable functional group X to the benzene ring by only -O(CH₂)ₙ-, an improvement in the chemical stability can be achieved. Further, an organic electronic material or the like having an excellent operational lifespan can be provided.

The organic electronic material II of one embodiment can be used favorably in organic electronic elements. Further, the organic electronic material II of this embodiment is suitable for use in ink compositions for wet processes.

Further, surprisingly, by using the organic electronic material II of this embodiment, effects including an improvement in the emission characteristics of organic EL elements, a reduction in the drive voltage, an improvement in the emission efficiency, and an improvement in the emission lifespan can be obtained. Although conjecture, it is thought that because the charge transport polymer II includes a structure in which the benzene ring and the polymerizable functional group Xa are linked only by an alkylene group, alkyl chain linkage portions are formed between polymer molecules, thereby improving the resistance to attacks on the polymer by Lewis bases and Lewis acid components that are generated during operation of the organic EL element, thus suppressing material degradation. Further, it is also thought that by forming alkyl chain linkage portions from which the polar group has been removed between the polymer molecules, the surface of the polymer molecules adopt a high LUMO and deep HOMO state, and become stable with respect to carriers such as holes and electrons, meaning deterioration during element operation can be suppressed.

### [Charge Transport Polymers]

### (Charge Transport Polymer I)

The charge transport polymer I has the ability to transport an electric charge. In the organic electronic material I according to one embodiment, the charge transport polymer I includes at least one structure which has the polymerizable functional group X, and is selected from the group consisting of a structure represented by formula (1) shown above, a structure represented formula (2) shown above and a structure represented formula (3) shown above (hereafter the structure represented by formula (1), the structure represented by formula (2) and the structure represented by formula (3) are also referred to as the structure of formula (1), the structure of formula (2) and the structure of formula (3) respectively). The charge transport polymer I may include a plurality of structures represented by formula (1), (2) or (3). In those cases where the charge transport polymer I includes a plurality of structures represented by formula (1), (2) or (3), the plurality of structures may be the same or different.

In formulas (1) to (3), X represents a polymerizable functional group selected from the group consisting of a substituted or unsubstituted oxetane group and a substituted or unsubstituted vinyl group. A "polymerizable functional group" refers to a group that is able to form a bond with each other upon the application of heat and/or light.

The polymerizable functional group X is preferably a polymerizable functional group selected from the group consisting of substituted or unsubstituted oxetane groups and substituted or unsubstituted vinyl groups. In a case in which the polymerizable functional group X is an oxetane group having a substituent or a vinyl group having a substituent, there are no particular limitations on the substituent, and examples include linear, cyclic or branched alkyl groups of 1 to 22 carbon atoms (and more preferably 1 to 10 carbon atoms), and aryl groups or heteroaryl groups of 2 to 20 carbon atoms. These substituents may also have a further substituent. Examples of vinyl groups having a substituent include substituted or unsubstituted styryl groups. Examples of oxetane groups having a substituent include oxetane groups having a linear, cyclic or branched alkyl group of 1 to 22 carbon atoms (and more preferably 1 to 10 carbon atoms). A substituted or unsubstituted oxetane group is particularly preferred as the polymerizable functional group X.

In formulas (1) to (3), n is preferably from 1 to 12. From the viewpoint of ensuring favorable solubility, n is preferably at least 1, more preferably at least 2, and even more preferably 6 or greater.

From the viewpoint of shortening the bonding distance between polymer molecules, and enhancing the carrier transport properties by hopping, n is preferably not too large. n is preferably not more than 12, and for example, may be not more than 8, or 4 or less.

Specific examples of structures represented by formula (1), (2) or (3) are shown below. However, the structures represented by formula (1), (2) or (3) are not limited to those shown below. In the following specific examples, "*" represents a bonding site for bonding to another structure.

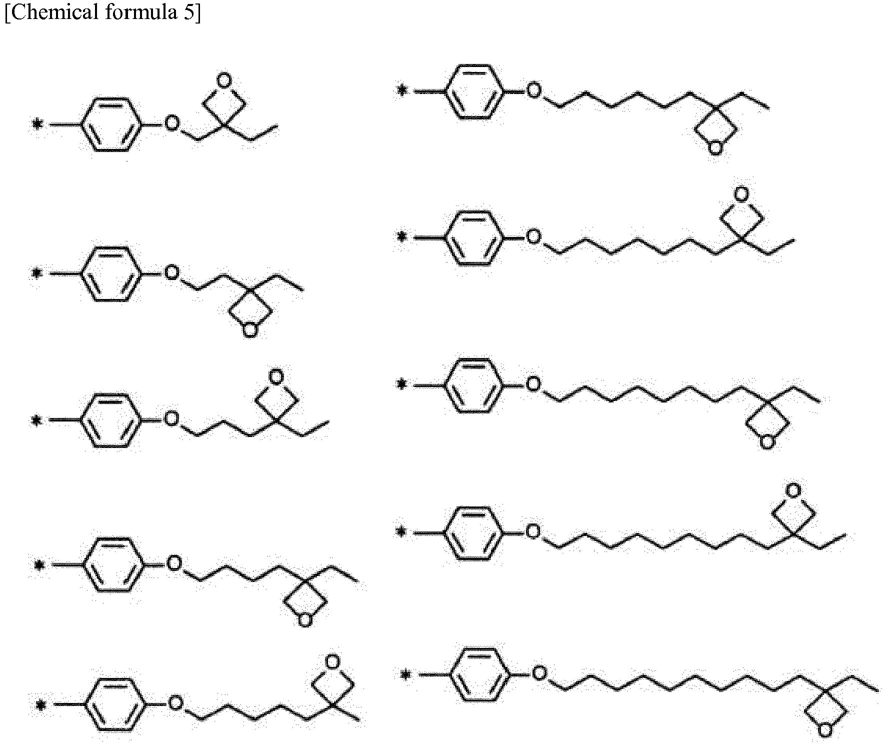

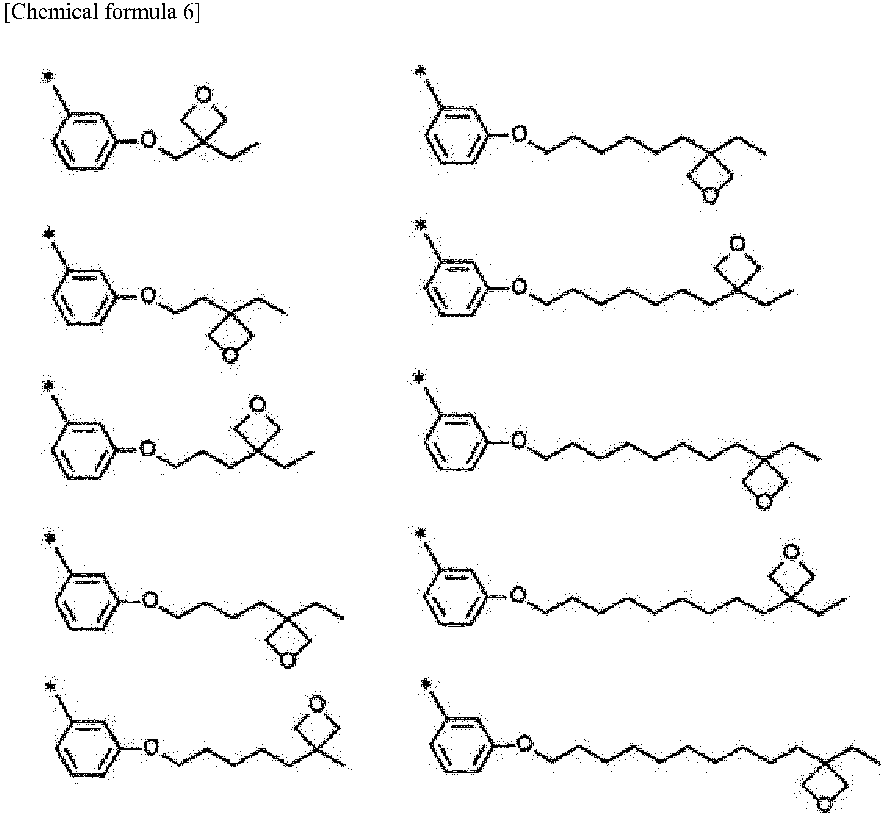

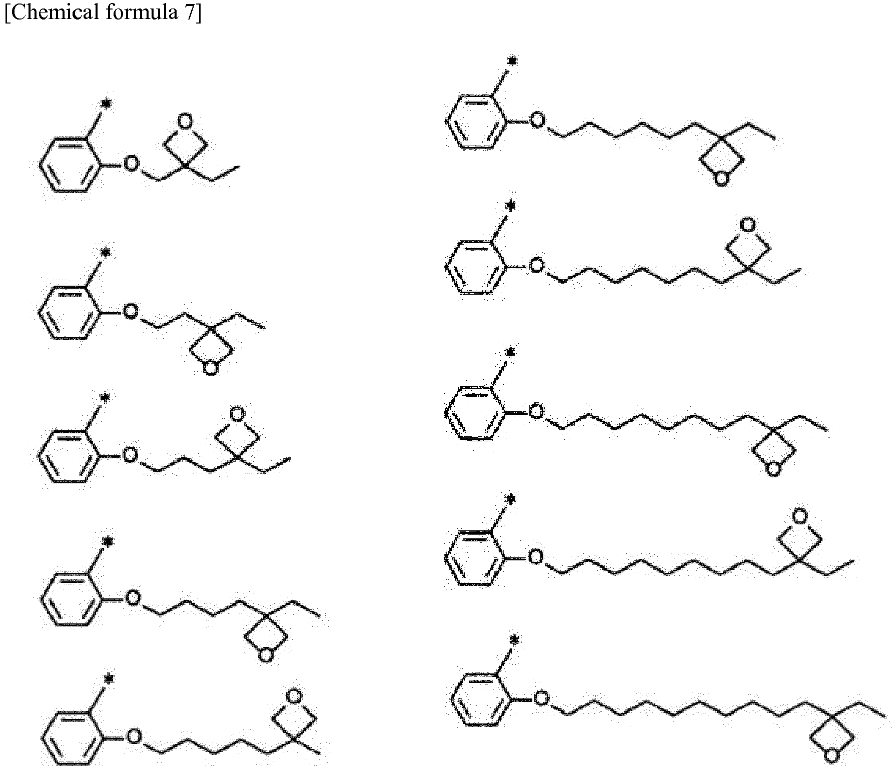

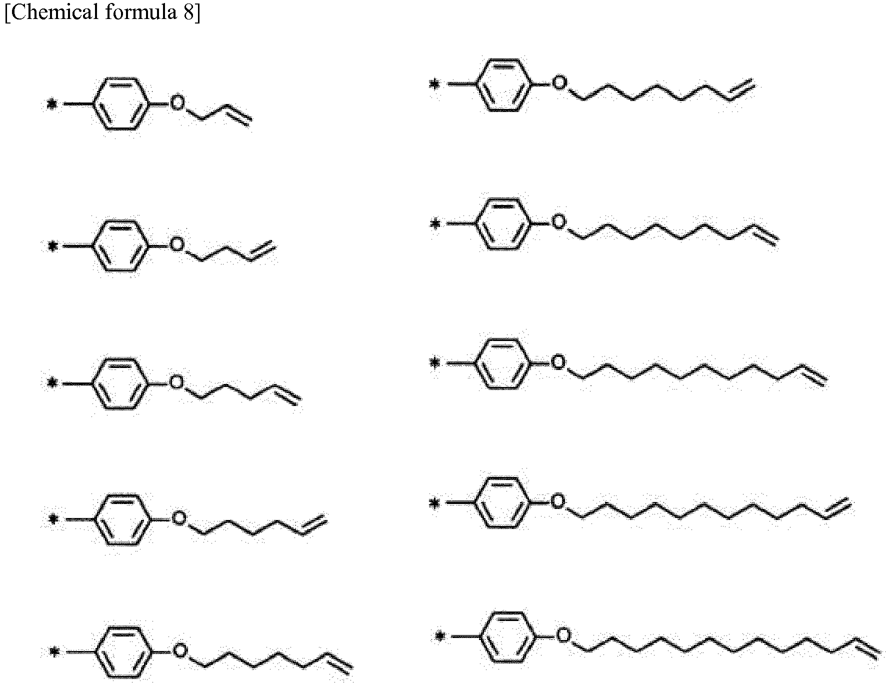

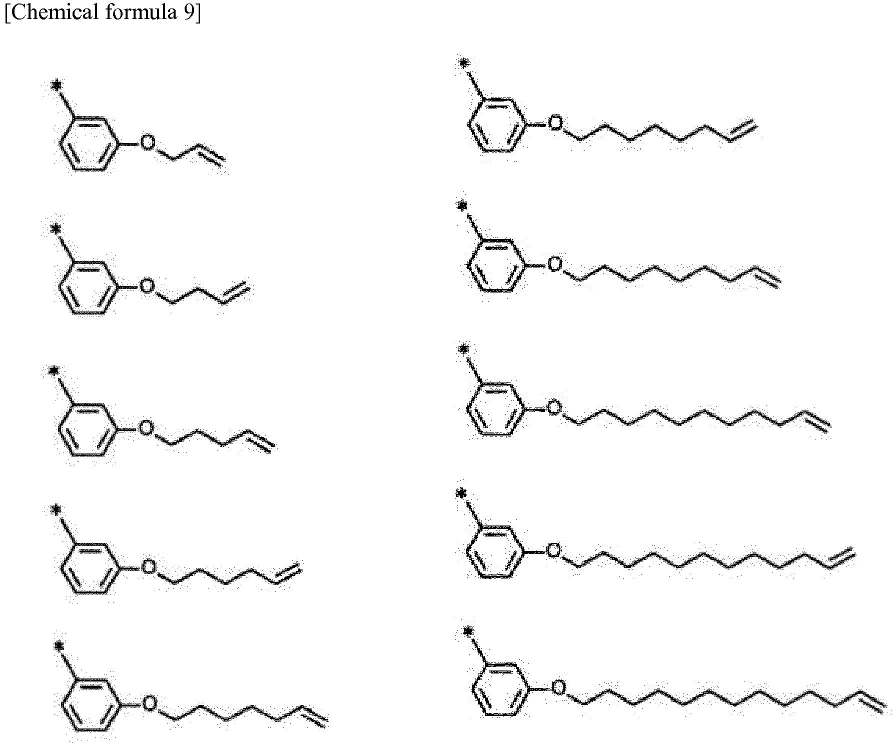

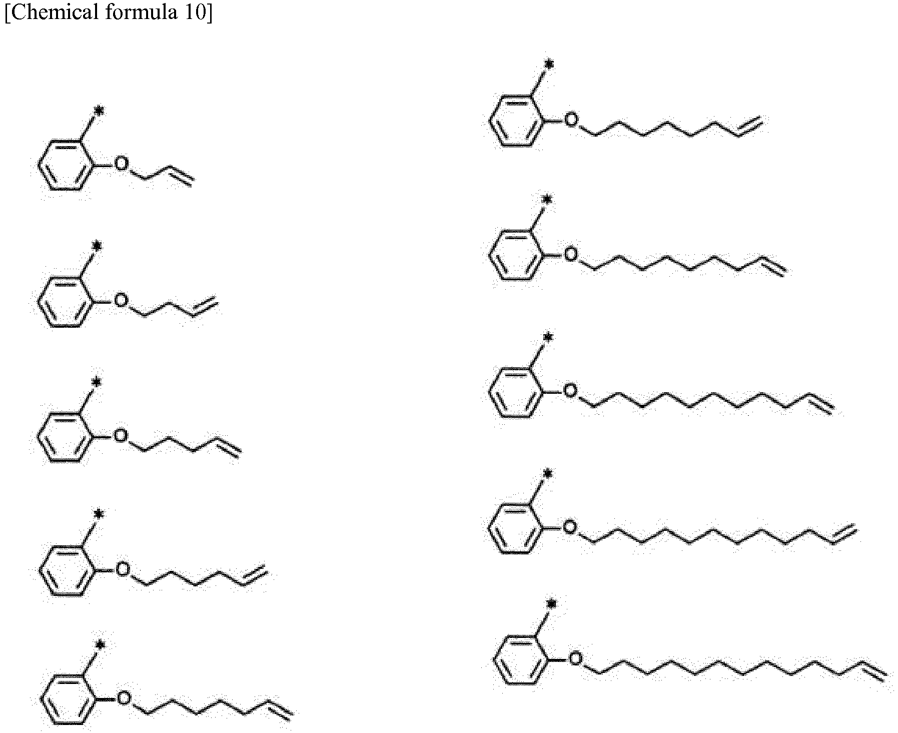

The structure represented by formula (1), (2) or (3) may be introduced at a terminal portion of the charge transport polymer I (namely, a structural unit T described below), at a portion other than a terminal portion (namely, a structural unit L or B described below), or at both a terminal portion and a portion other than a terminal portion. From the viewpoint of the curability, the structure represented by formula (1), (2) or (3) is preferably introduced at least at a terminal portion. From the viewpoint of achieving a combination of favorable curability and charge transport properties, the structure represented by formula (1), (2) or (3) is preferably introduced only at terminal portion(s). In those cases where the charge transport polymer I has a branched structure, the structure represented by formula (1), (2) or (3) having the polymerizable functional group X may be introduced within the main chain of the charge transport polymer I, within a side chain, or within both the main chain and a side chain.

From the viewpoint of contributing to a change in the solubility, the polymerizable functional group is preferably included in the charge transport polymer I in a large amount. On the other hand, from the viewpoint of not impeding the charge transport properties, the amount included in the charge transport polymer I is preferably kept small. The amount of the structure represented by formula (1), (2) or (3), or the amount of the polymerizable functional group X, may be set as appropriate with due consideration of these factors.

For example, from the viewpoint of obtaining a satisfactory change in the solubility, the number of polymerizable functional groups X per molecule of the charge transport polymer I is preferably at least 2, and more preferably 3 or greater. Further, from the viewpoint of maintaining good charge transport properties, the number of polymerizable functional groups X is preferably not more than 1,000, and more preferably 500 or fewer.

The number of structures represented by formula (1), (2) or (3) per molecule of the charge transport polymer I can be determined as an average value using the amount of the structure represented by formula (1), (2) or (3) (the amount added of the monomer) used in synthesizing the charge transport polymer I, the amounts added of the monomers corresponding with respective structural units used in synthesizing the charge transport polymer I, and the weight average molecular weight of the charge transport polymer I and the like. The number of polymerizable functional groups can be calculated as an average value using the ratio between the integral of the signal attributable to the polymerizable functional group and the integral of the total spectrum in the ¹H-NMR (nuclear magnetic resonance) spectrum of the charge transport polymer I, and the weight average molecular weight of the charge transport polymer I and the like. In terms of ease of calculation, in a case in which the amounts added of the various components are clear, then the value determined using these amounts is preferably employed.

### (Charge Transport Polymer II)

The charge transport polymer II has the ability to transport an electric charge. In the organic electronic material II according to one embodiment, the charge transport polymer II includes at least one structure which has the polymerizable functional group Xa, and is selected from the group consisting of a structure represented by formula (1a) shown above, a structure represented by formula (2a) shown above and a structure represented by formula (3a) shown above (hereafter the structure represented by formula (1a), the structure represented by formula (2a) and the structure represented by formula (3a) are also referred to as the structure of formula (1a), the structure of formula (2a) and the structure of formula (3a) respectively). The charge transport polymer II may include a plurality of structures represented by formula (1a), (2a) or (3a). In those cases where the charge transport polymer II includes a plurality of structures represented by formula (1a), (2a) or (3a), the plurality of structures may be the same or different.

In formulas (1a) to (3a), Xa represents a polymerizable functional group. As described above, a "polymerizable functional group" refers to a group that is able to form a bond with each other upon the application of heat and/or light.

Examples of the polymerizable functional group Xa include substituted or unsubstituted groups having a carbon-carbon multiple bond (such as a vinyl group, an allyl group, a butenyl group, an ethynyl group, an acryloyl group, an acryloyloxy group, an acryloylamino group, a methacryloyl group, a methacryloyloxy group, a methacryloylamino group, a vinyloxy group, a vinylamino group and a vinylphenyl group), groups having a small ring (examples thereof including cyclic alkyl groups such as a cyclopropyl group and a cyclobutyl group; cyclic ether groups such as an epoxy group (oxiranyl group) and an oxetane group (oxetanyl group); diketene groups; episulfide groups; lactone groups; and lactam groups), and heterocyclic groups (such as a furanyl group, a pyrrolyl group, a thiophenyl group and a silolyl group). In those cases where these groups are substituted, there are no particular limitations on the substituent, and examples of the substituent include linear, cyclic or branched alkyl groups of 1 to 22 carbon atoms (and more preferably 1 to 10 carbon atoms).

Particularly preferred polymerizable functional groups Xa include a substituted or unsubstituted vinyl group, a substituted or unsubstituted acryloyl group, a substituted or unsubstituted methacryloyl group, a substituted or unsubstituted epoxy group and a substituted or unsubstituted oxetane group, and from the viewpoint of the reactivity and the characteristics of the organic electronic element, a substituted or unsubstituted vinyl group, a substituted or unsubstituted oxetane group or a substituted or unsubstituted epoxy group is more preferred, and a substituted or unsubstituted oxetane group is the most desirable. Specific examples of the substituted or unsubstituted oxetane group include the substituted or unsubstituted oxetane group shown in the following specific examples of the polymerizable functional group Xa.

Specific examples of the polymerizable functional group Xa are shown below. The polymerizable functional group Xa is not limited to the structures shown below.

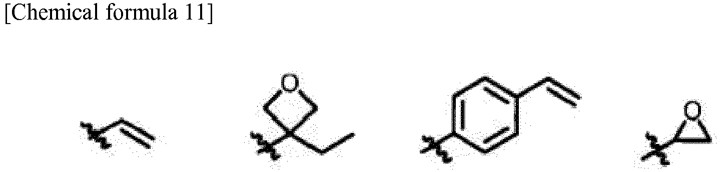

In formulas (1a) to (3a), the number m of carbon atoms linking the polymerizable functional group Xa and the benzene ring is preferably from 1 to 30. From the viewpoint of improving the polymer solubility, m is preferably at least 4, more preferably at least 6, and even more preferably 8 or greater. From the viewpoint of shortening the bonding distance between polymer molecules, and enhancing the carrier transport properties by hopping, m is preferably not more than 8, more preferably not more than 6, and even more preferably 4 or less.

Specific examples of structures represented by formula (1a), (2a) or (3a) are shown below. However, the structures represented by formula (1a), (2a) or (3a) are not limited to those shown below. In the following specific examples, "*" represents a bonding site for bonding to another structure.

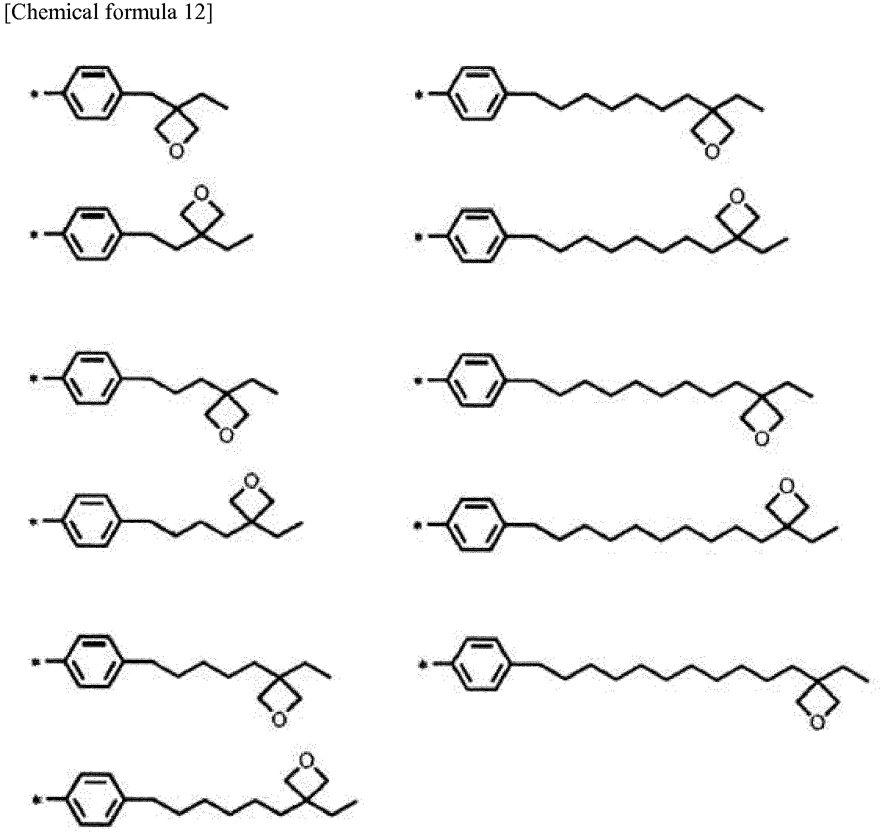

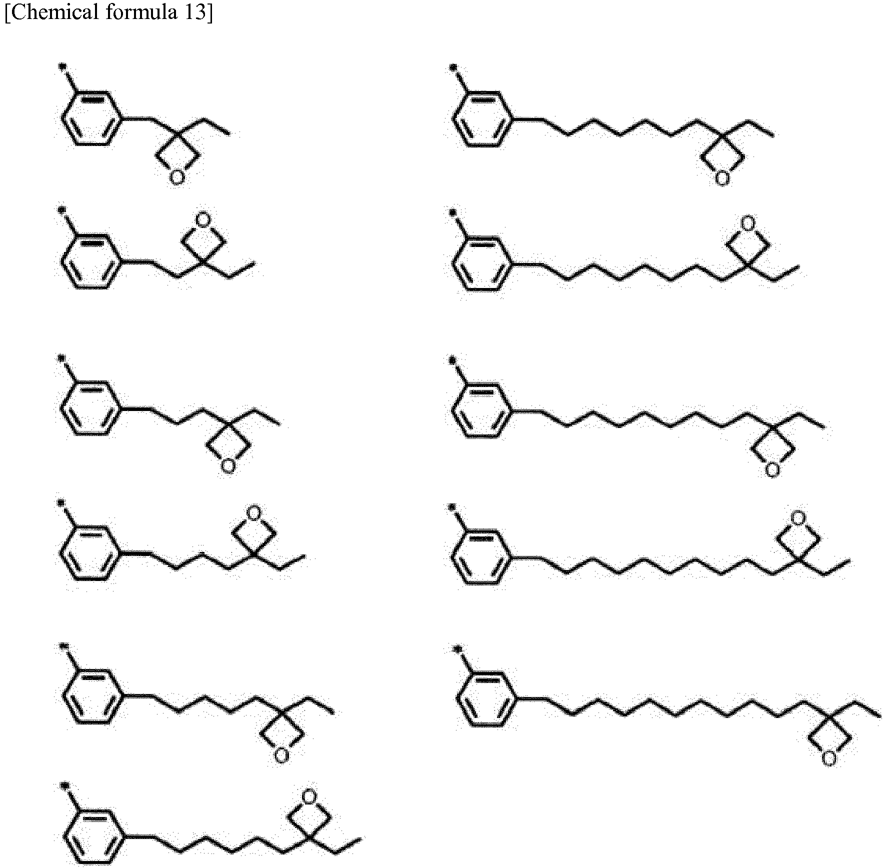

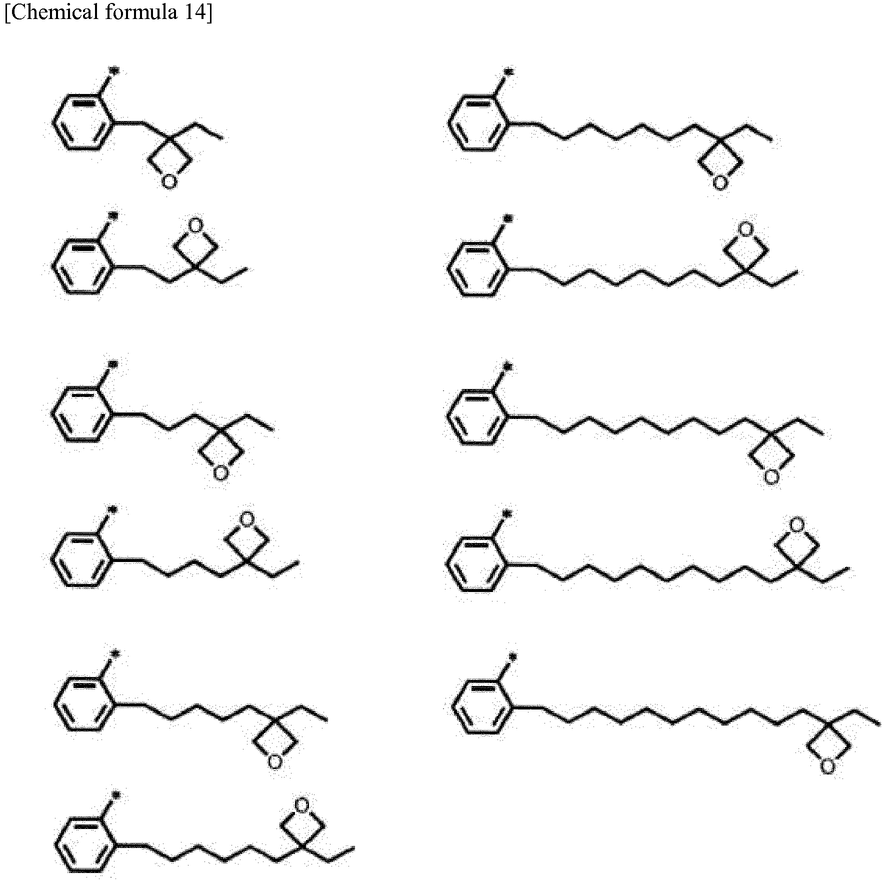

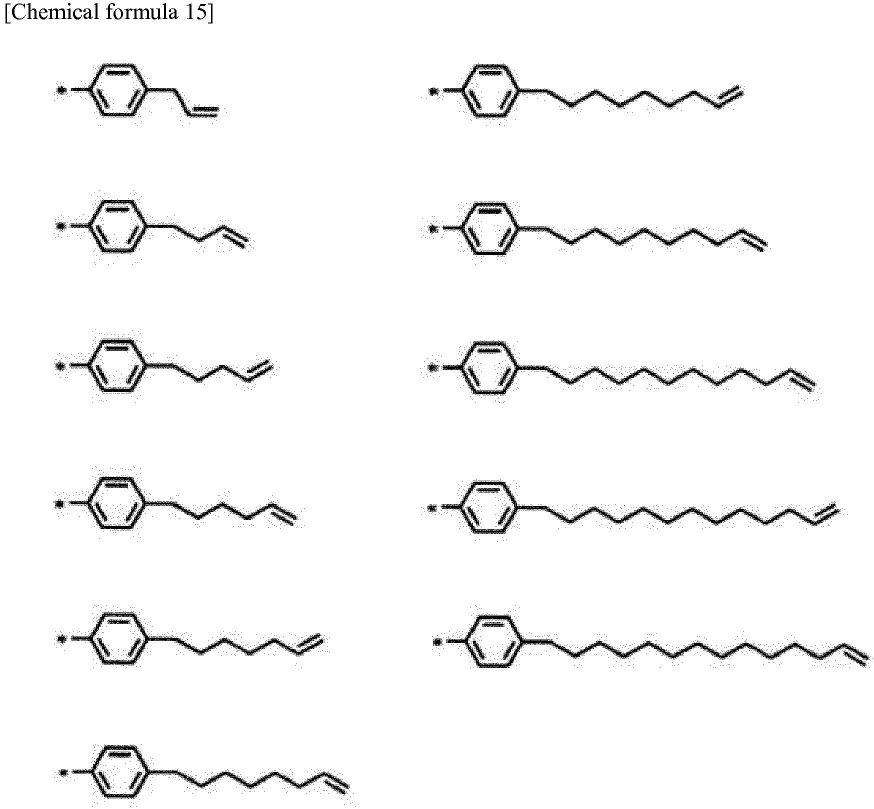

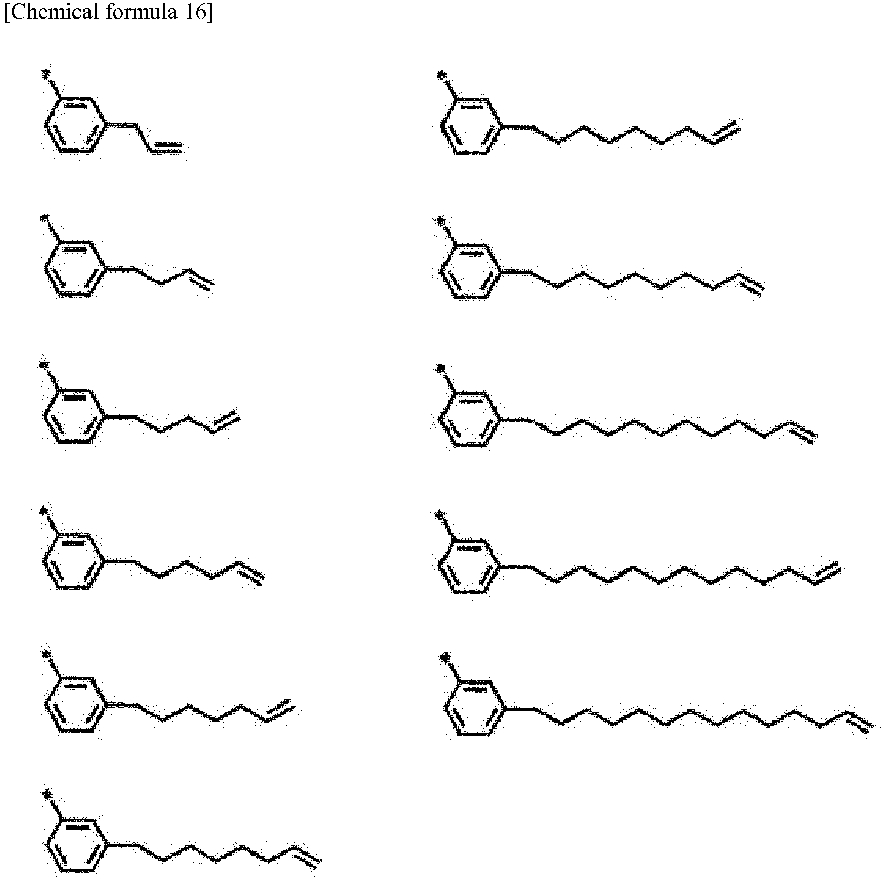

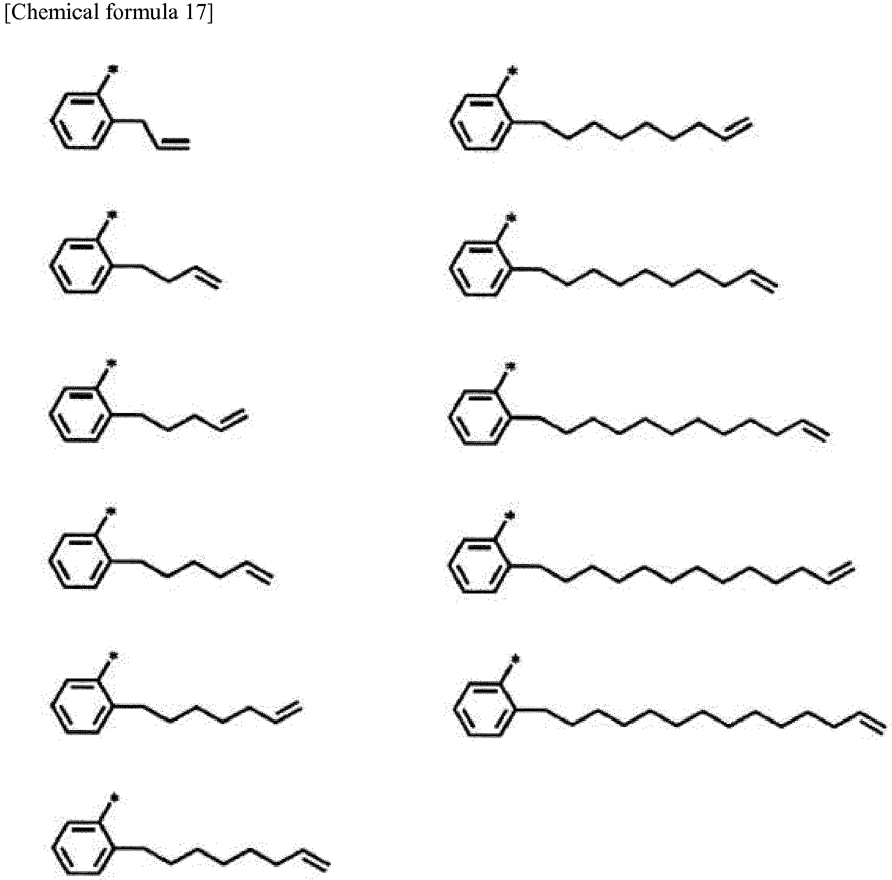

The structure represented by formula (1a), (2a) or (3a) may be introduced at a terminal portion of the charge transport polymer II (namely, a structural unit T described below), at a portion other than a terminal portion (namely, a structural unit L or B described below), or at both a terminal portion and a portion other than a terminal portion. From the viewpoint of the curability, the structure represented by formula (1a), (2a) or (3a) is preferably introduced at least at a terminal portion. From the viewpoint of achieving a combination of favorable curability and charge transport properties, the structure represented by formula (1a), (2a) or (3a) is preferably introduced only at terminal portion(s). In those cases where the charge transport polymer II has a branched structure, the structure represented by formula (1a), (2a) or (3a) having the polymerizable functional group Xa may be introduced within the main chain of the charge transport polymer II, within a side chain, or within both the main chain and a side chain.

From the viewpoint of contributing to a change in the solubility, the polymerizable functional group is preferably included in the charge transport polymer II in a large amount. On the other hand, from the viewpoint of not impeding the charge transport properties, the amount included in the charge transport polymer II is preferably kept small. The amount of the structure represented by formula (1a), (2a) or (3a), or the amount of the polymerizable functional group Xa, may be set as appropriate with due consideration of these factors.

For example, from the viewpoint of obtaining a satisfactory change in the solubility, the number of polymerizable functional groups Xa per molecule of the charge transport polymer II is preferably at least 2, and more preferably 3 or greater. Further, from the viewpoint of maintaining good charge transport properties, the number of polymerizable functional groups Xa is preferably not more than 1,000, and more preferably 500 or fewer.

The number of structures represented by formula (1a), (2a) or (3a) per molecule of the charge transport polymer II can be determined as an average value using the amount of the structure represented by formula (1a), (2a) or (3a) (the amount added of the monomer) used in synthesizing the charge transport polymer II, the amounts added of the monomers corresponding with the respective structural units used in synthesizing the charge transport polymer II, and the weight average molecular weight of the charge transport polymer II and the like. The number of polymerizable functional groups can be calculated as an average value using the ratio between the integral of the signal attributable to the polymerizable functional group and the integral of the total spectrum in the ¹H-NMR (nuclear magnetic resonance) spectrum of the charge transport polymer II, and the weight average molecular weight of the charge transport polymer II and the like. In terms of ease of calculation, in a case in which the amounts added of the various components are clear, then the value determined using these amounts is preferably employed.

### (Structures of Charge Transport Polymers I and II)

Specific examples of the structures of the charge transport polymers I and II in embodiments of the present invention are described below.

The charge transport polymers I and II may each have a linear or branched structure. The charge transport polymers I and II preferably each contain at least a divalent structural unit L having charge transport properties and a monovalent structural unit T that forms the terminal portions, and may also contain a trivalent or higher valent structural unit B that forms a branched portion. The charge transport polymers I and II may each include only one type or two more types of each of these structural units. In the charge transport polymers I and II, the structural units are bonded together at "monovalent" to "trivalent or higher valent" bonding sites.

Examples of partial structures contained in the charge transport polymer I and partial structures contained in the charge transport polymer II are described below. However, the charge transport polymers I and II are not limited to polymers having the following partial structures. In the partial structures, "L" represents a structural unit L, "T" represents a structural unit T, and "B" represents a structural unit B. In the present description, an "*" in a formula represents a bonding site for bonding to another structural unit. In the following partial structures, the plurality of L units may be structural units having the same structure or structural units having mutually different structures. This also applies for the B and T structural units.

### Linear Charge Transport Polymer

[Chemical formula 18] T-L-L-L-L-L-·

### Charge Transport Polymers having Branched Structure

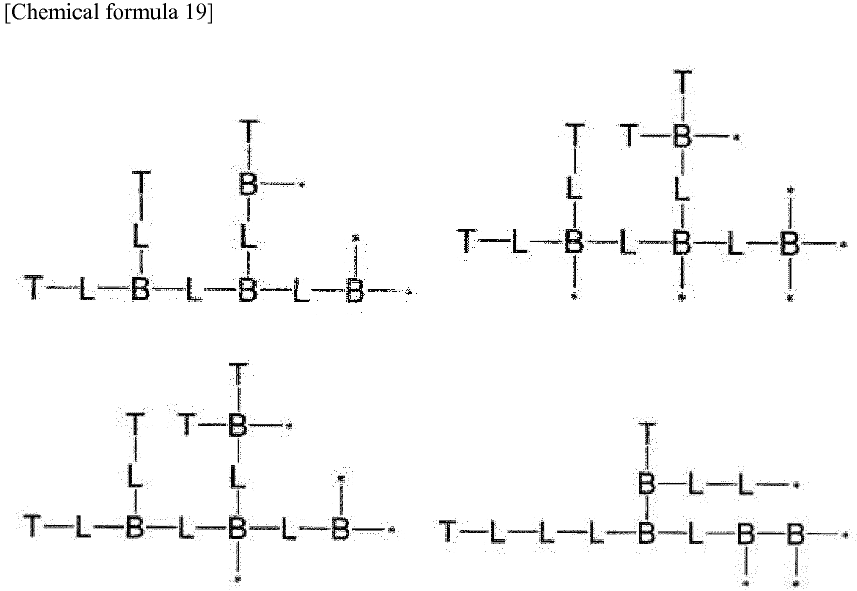

### (Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted aromatic amine structures, substituted or unsubstituted carbazole structures, substituted or unsubstituted thiophene structures, substituted or unsubstituted fluorene structures, substituted or unsubstituted benzene structures, substituted or unsubstituted biphenyl structures, substituted or unsubstituted terphenyl structures, substituted or unsubstituted naphthalene structures, substituted or unsubstituted anthracene structures, substituted or unsubstituted tetracene structures, substituted or unsubstituted phenanthrene structures, substituted or unsubstituted dihydrophenanthrene structures, substituted or unsubstituted pyridine structures, substituted or unsubstituted pyrazine structures, substituted or unsubstituted quinoline structures, substituted or unsubstituted isoquinoline structures, substituted or unsubstituted quinoxaline structures, substituted or unsubstituted acridine structures, substituted or unsubstituted diazaphenanthrene structures, substituted or unsubstituted furan structures, substituted or unsubstituted pyrrole structures, substituted or unsubstituted oxazole structures, substituted or unsubstituted oxadiazole structures, substituted or unsubstituted thiazole structures, substituted or unsubstituted thiadiazole structures, substituted or unsubstituted triazole structures, substituted or unsubstituted benzothiophene structures, substituted or unsubstituted benzoxazole structures, substituted or unsubstituted benzoxadiazole structures, benzothiazole structures, substituted or unsubstituted benzothiadiazole structures, substituted or unsubstituted benzotriazole structures, and structures containing one, or two or more, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted aromatic amine structures, substituted or unsubstituted carbazole structures, substituted or unsubstituted thiophene structures, substituted or unsubstituted fluorene structures, substituted or unsubstituted benzene structures, substituted or unsubstituted pyrrole structures, and structures containing one, or two or more, of these structures, and is more preferably selected from among substituted or unsubstituted aromatic amine structures, substituted or unsubstituted carbazole structures, and structures containing one, or two or more, of these structures. In another embodiment, from the viewpoint of obtaining superior electron transport properties, the structural unit L is preferably selected from among substituted or unsubstituted fluorene structures, substituted or unsubstituted benzene structures, substituted or unsubstituted phenanthrene structures, substituted or unsubstituted pyridine structures, substituted or unsubstituted quinoline structures, and structures containing one, or two or more, of these structures.

In one embodiment, the structural unit L may include a structure selected from the group consisting of substituted or unsubstituted aromatic amine structures, substituted or unsubstituted carbazole structures, substituted or unsubstituted thiophene structures, substituted or unsubstituted bithiophene structures, substituted or unsubstituted benzene structures, substituted or unsubstituted polycyclic aromatic structures in which a plurality of benzene rings are condensed, and substituted or unsubstituted fluorene structures. Examples of the polycyclic aromatic structures in which a plurality of benzene rings are condensed include naphthalene, anthracene, phenanthrene, pyrene and benzopyrene.

In one embodiment, the charge transport polymer I may include a structural unit L containing a structure represented by formula (1), (2) or (3).

In one embodiment, the charge transport polymer II may include a structural unit L containing a structure represented by formula (1a), (2a) or (3a).

Specific examples of the structural unit L are shown below. The structural unit L is not limited to the following structures.

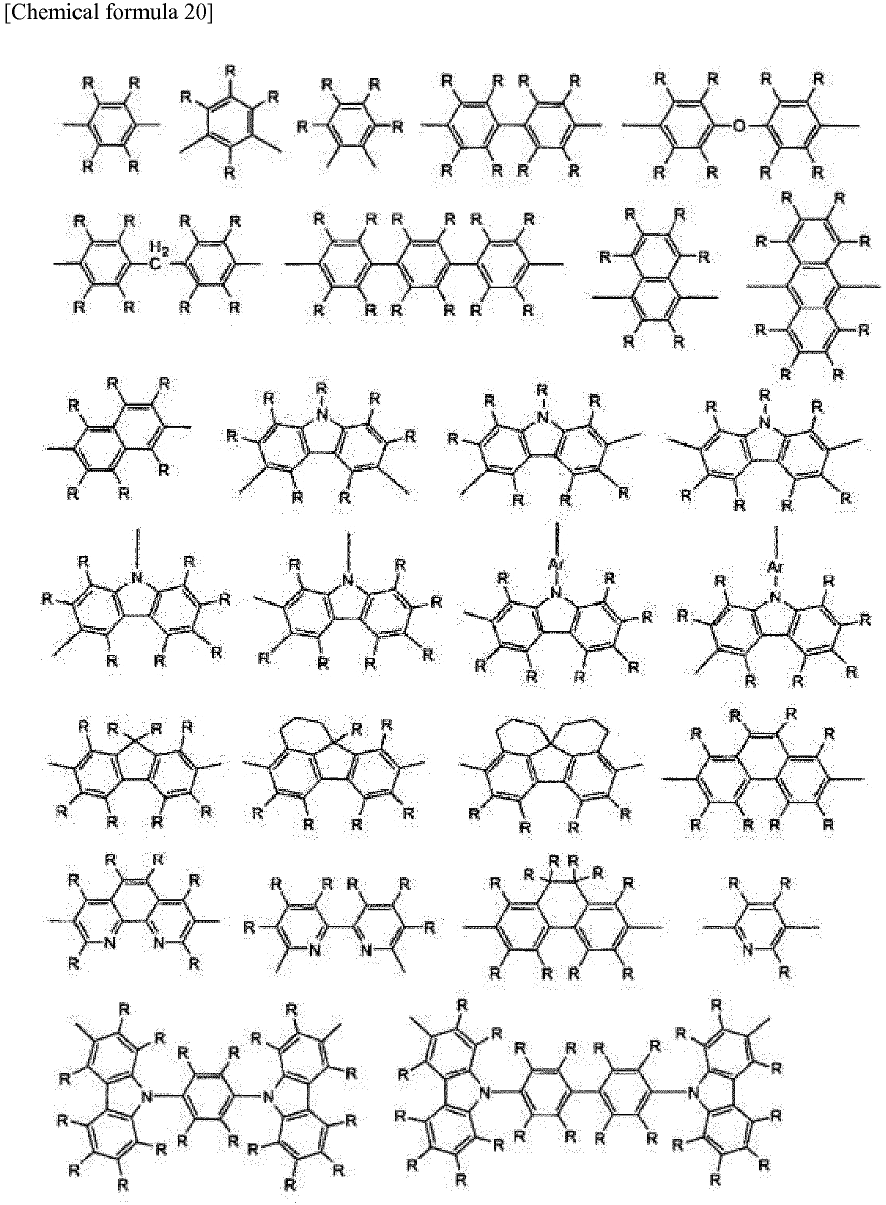

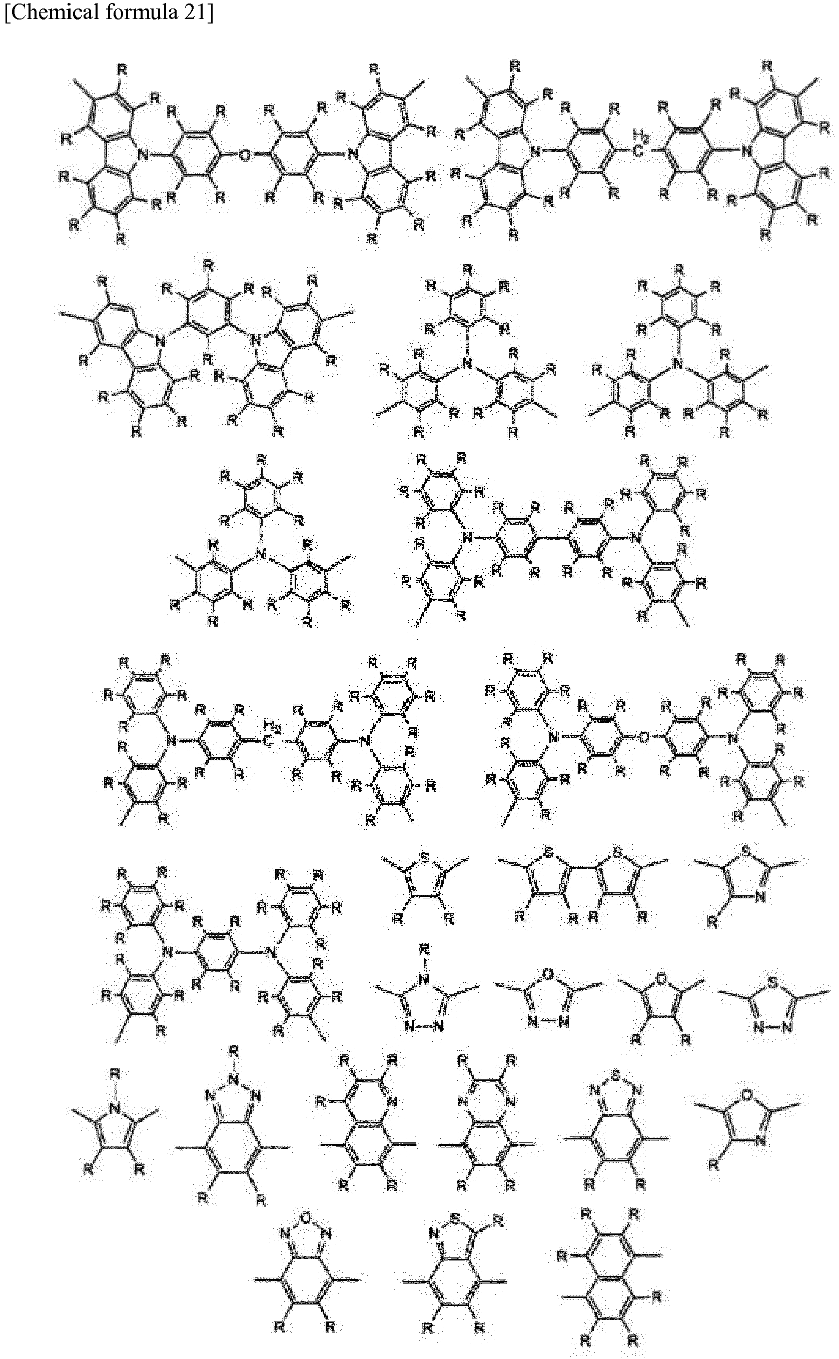

Each R independently represents a hydrogen atom or a substituent. In the charge transport polymer I, it is preferable that each R is independently selected from the group consisting of -R¹, -OR², -SR³, -OCOR⁴, -COOR⁵, -SiR⁶R⁷R⁸, halogen atoms, and structures represented by formula (1), (2) or (3). In the charge transport polymer II, it is preferable that each R is independently selected from the group consisting of -R¹, -OR², -SR³, -OCOR⁴, -COOR⁵, -SiR⁶R⁷R⁸, halogen atoms, and groups containing a polymerizable functional group, wherein examples of the polymerizable functional group include the groups mentioned above as examples of the polymerizable functional group Xa, and examples of the groups containing a polymerizable functional group include structures represented by one of the above formulas (1a), (2a) or (3a).

Each of R¹ to R⁸ independently represents a hydrogen atom, a linear, cyclic or branched alkyl group of 1 to 22 carbon atoms, or an aryl group or heteroaryl group of 2 to 30 carbon atoms. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms.

R is preferably a hydrogen atom, an alkyl group, an aryl group, or an alkyl-substituted aryl group.

Ar represents an arylene group or heteroarylene group of 2 to 30 carbon atoms. Ar is preferably an arylene group, and is more preferably a phenylene group.

### (Structural Unit T)

The structural unit T is a monovalent structural unit that constitutes a terminal portion of the charge transport polymer. There are no particular limitations on the structural unit T, which may be selected from among substituted or unsubstituted aromatic hydrocarbon structures, substituted or unsubstituted aromatic heterocyclic structures, and structures containing one, or two or more, of these structures. In one embodiment, from the viewpoint of imparting durability without impairing the charge transport properties, the structural unit T is preferably a substituted or unsubstituted aromatic hydrocarbon structure, and is more preferably a substituted or unsubstituted benzene structure. In another embodiment, in a case in which the charge transport polymer has a polymerizable functional group at a terminal portion, the structural unit T may be a polymerizable structure (for example, a polymerizable functional group such as a pyrrolyl group). The structural unit T may include the same structure as or a different structure from the structural unit L.

In one embodiment, the charge transport polymer I may include a structural unit T containing a structure represented by formula (1), (2) or (3).

In one embodiment, the charge transport polymer II may include a structural unit T containing a structure represented by formula (1a), (2a) or (3a).

Specific examples of the structural unit T are shown below. The structural unit T is not limited to the following structures.

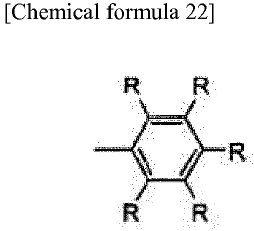

R is the same as R as explained for the structural unit L.

In those cases where the charge transport polymer I includes a structural unit T having a structure represented by formula (1), (2) or (3), in one embodiment, it is preferable that one R is represented by a formula shown below, and the other R groups are hydrogen atoms. In the formula shown below, X and n are as defined for X and n in formula (1), (2) or (3), and the preferred ranges are also the same as described above.

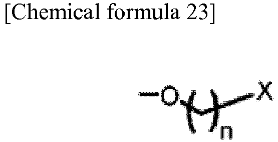

In those cases where the charge transport polymer II includes a structural unit T having a structure represented by formula (1a), (2a) or (3a), in one embodiment, it is preferable that one R is represented by a formula shown below, and the other R groups are hydrogen atoms. In the formula shown below, Xa and m are as defined for Xa and m in formula (1a), (2a) or (3a), and the preferred ranges are also the same as described above.

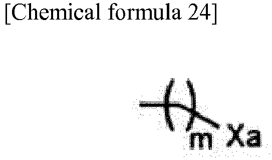

### (Structural Unit B)

The structural unit B is a trivalent or higher valent structural unit that constitutes a branched portion in those cases where the charge transport polymer has a branched structure. From the viewpoint of improving the durability of the organic electronic element, the structural unit B is preferably not higher than hexavalent, and is more preferably either trivalent or tetravalent. The structural unit B is preferably a unit that has charge transport properties. For example, from the viewpoint of improving the durability of the organic electronic element, the structural unit B is preferably selected from among substituted or unsubstituted aromatic amine structures, substituted or unsubstituted carbazole structures, substituted or unsubstituted condensed polycyclic aromatic hydrocarbon structures, and structures containing one, or two or more, of these structures. The structural unit B may include the same structure as or a different structure from the structural unit L. The structural unit B may include the same structure as or a different structure from the structural unit T.

In one embodiment, the structural unit B may include a structure selected from the group consisting of substituted or unsubstituted aromatic amine structures, substituted or unsubstituted carbazole structures, substituted or unsubstituted thiophene structures, substituted or unsubstituted bithiophene structures, substituted or unsubstituted benzene structures, substituted or unsubstituted polycyclic aromatic structures in which a plurality of benzene rings are condensed, and substituted or unsubstituted fluorene structures.

Examples of the polycyclic aromatic structures in which a plurality of benzene rings are condensed include naphthalene, anthracene, phenanthrene, pyrene and benzopyrene.

In one embodiment, the charge transport polymer I may include a structural unit B containing a structure represented by formula (1), (2) or (3).

In one embodiment, the charge transport polymer II may include a structural unit B containing a structure represented by formula (1a), (2a) or (3a).

Specific examples of the structural unit B are shown below. The structural unit B is not limited to the following structures.

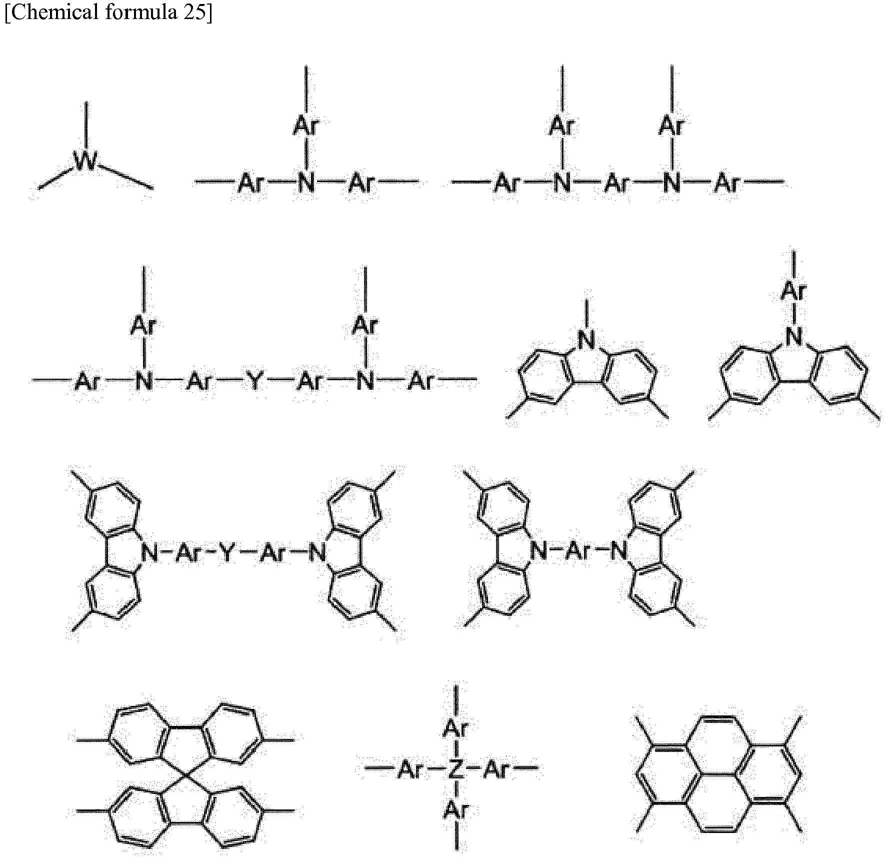

W represents a trivalent linking group, and for example, may represent an arenetriyl group or heteroarenetriyl group of 2 to 30 carbon atoms. Each Ar independently represents a divalent linking group, and for example, may represent an arylene group or heteroarylene group of 2 to 30 carbon atoms. Ar preferably represents an arylene group, and more preferably a phenylene group. Y represents a divalent linking group, and examples include divalent groups in which a hydrogen atom has been further removed from any of the R groups having one or more hydrogen atoms (but excluding groups containing a polymerizable functional group) described above in relation to the structural unit L. Z represents a carbon atom, a silicon atom or a phosphorus atom. In the structural units, the benzene rings, Ar groups and W group may have a substituent, and examples of the substituent include the R groups as explained for the structural unit L.

### (Proportions of Structural Units)

From the viewpoint of ensuring satisfactory charge transport properties, the proportion of the structural unit L contained in the charge transport polymer I, relative to the total of all the structural units, is preferably at least 10 mol%, more preferably at least 20 mol%, and even more preferably 30 mol% or higher. If the structural unit T and the optionally included structural unit B are taken into consideration, then the proportion of the structural unit L contained in the charge transport polymer I is preferably not more than 95 mol%, more preferably not more than 90 mol%, and even more preferably 85 mol% or less.

The preferred range for the proportion of the structural unit L contained in the charge transport polymer II is the same as the preferred range for the proportion of the structural unit L contained in the charge transport polymer I described above.

From the viewpoint of improving the characteristics of the organic electronic element, or from the viewpoint of suppressing any increase in viscosity and enabling more favorable synthesis of the charge transport polymer, the proportion of the structural unit T contained in the charge transport polymer I, relative to the total of all the structural units, is preferably at least 5 mol%, more preferably at least 10 mol%, and even more preferably 15 mol% or higher. From the viewpoint of ensuring satisfactory charge transport properties, the proportion of the structural unit T in the charge transport polymer I is preferably not more than 60 mol%, more preferably not more than 55 mol%, and even more preferably 50 mol% or less.

The preferred range for the proportion of the structural unit T contained in the charge transport polymer II is the same as the preferred range for the proportion of the structural unit L contained in the charge transport polymer I described above.

In those cases where the charge transport polymer I includes a structural unit B, from the viewpoint of improving the durability of the organic electronic element, the proportion of the structural unit B contained in the charge transport polymer I, relative to the total of all the structural units, is preferably at least 1 mol%, more preferably at least 5 mol%, and even more preferably 10 mol% or higher. Further, in those cases where the charge transport polymer I includes a structural unit B, from the viewpoints of suppressing any increase in viscosity and enabling more favorable synthesis of the charge transport polymer, or from the viewpoint of ensuring satisfactory charge transport properties, the proportion of the structural unit B contained in the charge transport polymer I is preferably not more than 50 mol%, more preferably not more than 40 mol%, and even more preferably 30 mol% or less.

In those cases where the charge transport polymer II includes a structural unit B, the preferred range for the proportion of the structural unit B contained in the charge transport polymer II is the same as the aforementioned preferred range for the proportion of the structural unit L contained in the charge transport polymer I in those cases where the charge transport polymer I includes a structural unit B.

From the viewpoint of ensuring efficient curing of the charge transport polymer I, the proportion of the polymerizable functional group X in the charge transport polymer I, relative to the total of all the structural units, is preferably at least 0.1 mol%, more preferably at least 1 mol%, and even more preferably 3 mol% or higher. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group.

From the viewpoint of ensuring efficient curing of the charge transport polymer II, the proportion of the polymerizable functional group in the charge transport polymer II, relative to the total of all the structural units, is preferably at least 0.1 mol%, more preferably at least 1 mol%, and even more preferably 3 mol% or higher. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group.

In the charge transport polymer I, considering the balance between the charge transport properties, the durability and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer I includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The preferred range for the ratio (molar ratio) between the structural unit L and the structural unit T in the charge transport polymer II, and the preferred range for the ratio (molar ratio) between the structural unit L, the structural unit T and the structural unit B in those cases where the charge transport polymer II includes the structural unit B, are, respectively, the same as the aforementioned preferred range for the ratio (molar ratio) between the structural unit L and the structural unit T in the charge transport polymer I, and the preferred range for the ratio (molar ratio) between the structural unit L, the structural unit T and the structural unit B in the charge transport polymer I in those cases where the charge transport polymer I includes the structural unit B.

The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the ¹H-NMR spectrum of the charge transport polymer. In terms of ease of calculation, if the amount added of the monomer is clear, then the proportion of the structural unit preferably employs the value determined using the amount added of the monomer.

### (Number Average Molecular Weight)

The number average molecular weights of the charge transport polymer I and the charge transport polymer II can each be adjusted appropriately with due consideration of the solubility in solvents and the film formability and the like.

From the viewpoint of ensuring superior charge transport properties, the number average molecular weight of the charge transport polymer I is preferably at least 500, more preferably at least 1,000, and even more preferably 2,000 or greater. Further, from the viewpoints of maintaining favorable solubility in solvents and facilitating the preparation of ink compositions, the number average molecular weight of the charge transport polymer I is preferably not more than 1,000,000, more preferably not more than 100,000, and even more preferably 50,000 or less.

The preferred range for the number average molecular weight of the charge transport polymer II is the same as the preferred range for the number average molecular weight of the charge transport polymer I described above.

### (Weight Average Molecular Weight)

The weight average molecular weights of the charge transport polymer I and the charge transport polymer II can each be adjusted appropriately with due consideration of the solubility in solvents and the film formability and the like.

From the viewpoint of ensuring superior charge transport properties, the weight average molecular weight of the charge transport polymer I is preferably at least 1,000, more preferably at least 5,000, and even more preferably 10,000 or greater. Further, from the viewpoints of maintaining favorable solubility in solvents and facilitating the preparation of ink compositions, the weight average molecular weight of the charge transport polymer I is preferably not more than 1,000,000, more preferably not more than 700,000, and even more preferably 400,000 or less.

The preferred range for the weight average molecular weight of the charge transport polymer II is the same as the preferred range for the weight average molecular weight of the charge transport polymer I described above.

The number average molecular weight and the weight average molecular weight can be measured by gel permeation chromatography (GPC), using a calibration curve of standard polystyrenes.

The GPC measurement conditions may use the following conditions.
Apparatus: High-performance liquid chromatograph "Prominence", manufactured by Shimadzu Corporation
   Feed pump (LC-20AD)
   Degassing unit (DGU-20A)
   Autosampler (SIL-20AHT)
   Column oven (CTO-20A)
   PDA detector (SPD-M20A)
   Refractive index detector (RID-20A)
Columns: Gelpack (a registered trademark)
   GL-A160S / GL-A150S, manufactured by Hitachi Chemical Co., Ltd.
Eluent: Tetrahydrofuran (THF) (for HPLC, contains stabilizers), manufactured by Wako Pure Chemical Industries, Ltd.
Flow rate: 1 mL/min
Column temperature: 40°C
Detection wavelength: 254 nm
Molecular weight standards: Standard Polystyrene Kit PStQuick A/B/C, manufactured by Tosoh Corporation

### (Production Method)

The charge transport polymers I and II of embodiments of the present invention are each preferably a polymer or copolymer of a monomer containing a structural unit having hole transport properties. The charge transport polymers I and II can each be produced favorably by copolymerizing a monomer mixture containing one or more monomers containing the structural unit L described above and one or more monomers containing the structural unit T described above, and optionally containing a monomer containing the structural unit B described above. The copolymer may be an alternating, random, block or graft copolymer, or a copolymer having an intermediate type structure, such as a random copolymer having block-like properties.

The charge transport polymers I and II can each be produced by various synthesis methods, and there are no particular limitations. For example, conventional coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymers I and II can be produced easily by bonding together the desired aromatic rings.

In a coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymers I and II.

### [Dopant]

The organic electronic materials I and II may each include optional additives, and for example, may include a dopant. There are no particular limitations on the dopant, provided a doping effect is achieved by adding the dopant to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably performed, whereas to improve the electron transport properties, n-type doping is preferably performed. The dopant used in the organic electronic material may be a dopant that exhibits either a p-type doping effect or an n-type doping effect. Further, a single dopant may be added, or a mixture of a plurality of dopants may be added.

The dopants used in p-type doping are electron-accepting compounds, and examples include Lewis acids, protonic acids, transition metal compounds, ionic compounds, halides and π-conjugated compounds. Specific examples include Lewis acids such as FeCl₃, PFs, AsFs, SbFs, BFs, BCl₃ and BBr₃; protonic acids, including inorganic acids such as HF, HCl, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbFs, AlCl₃, NbCl₅, TaCls and MoF₅; ionic compounds, examples thereof including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halides such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

Further examples of the above ionic compounds include onium salts. Onium salts are compounds having a cation such as an iodonium or ammonium cation, and a counter anion.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In order to facilitate a change in the solubility of the organic layer, a compound that can function as a polymerization initiator for the polymerizable functional group is preferably used as the dopant.

### [Other Optional Components]

The organic electronic materials I and II may each also contain a charge transport low-molecular weight compound, another polymer, and/or the like.

### [Contents]

From the viewpoint of obtaining favorable charge transport properties, the amount of the charge transport polymer I in the organic electronic material I, relative to the total mass of the organic electronic material I, is preferably at least 50% by mass, more preferably at least 70% by mass, and even more preferably 80% by mass or greater. There are no particular limitations on the upper limit for the amount of the charge transport polymer I in the organic electronic material I, and the amount may be 100% by mass. If consideration is given to the inclusion of additives such as dopants, then the amount of the charge transport polymer I in the organic electronic material I may be, for example, not more than 99% by mass, not more than 98% by mass, not more than 95% by mass, or 90% by mass or less.

From the viewpoint of obtaining favorable charge transport properties, the amount of the charge transport polymer II in the organic electronic material II, relative to the total mass of the organic electronic material II, is preferably at least 50% by mass, more preferably at least 70% by mass, and even more preferably 80% by mass or greater. There are no particular limitations on the upper limit for the amount of the charge transport polymer II in the organic electronic material II, and the amount may be 100% by mass. If consideration is given to the inclusion of additives such as dopants, then the amount of the charge transport polymer II in the organic electronic material II may be, for example, not more than 99% by mass, not more than 98% by mass, not more than 95% by mass, or 90% by mass or less.

In those cases where the organic electronic material I includes a dopant, from the viewpoint of improving the charge transport properties of the organic electronic material I, the amount of the dopant relative to the total mass of the organic electronic material I is preferably at least 0.01% by mass, more preferably at least 0.1% by mass, and even more preferably 0.5% by mass or greater. From the viewpoint of maintaining favorable film formability, the amount of the dopant relative to the total mass of the organic electronic material I is preferably not more than 50% by mass, more preferably not more than 30% by mass, and even more preferably 20% by mass or less.

In those cases where the organic electronic material II includes a dopant, from the viewpoint of improving the charge transport properties of the organic electronic material II, the amount of the dopant relative to the total mass of the organic electronic material II is preferably at least 0.01% by mass, more preferably at least 0.1% by mass, and even more preferably 0.5% by mass or greater. From the viewpoint of maintaining favorable film formability, the amount of the dopant relative to the total mass of the organic electronic material II is preferably not more than 50% by mass, more preferably not more than 30% by mass, and even more preferably 20% by mass or less.

### <Ink Composition>

The organic electronic materials I and II of the embodiments described above may each exist in the form of an ink composition that also contains a solvent that is capable of dissolving or dispersing that material. By using this type of ink composition, an organic layer can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Polymerization Initiator]

The ink composition preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above. An aforementioned onium salt can be used favorably as a cationic polymerization initiator.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition may be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. The amount of the solvent is preferably an amount that yields a ratio of the charge transport polymer relative to the solvent that is not more than 20% by mass, more preferably not more than 15% by mass, and even more preferably 10% by mass or less.

### <Organic Layer>

An organic layer according to one embodiment of the present invention is a layer formed using the organic electronic material or the ink composition of an embodiment described above. By using the ink composition, an organic layer can be formed favorably and easily by a coating method. Examples of the coating method include conventional methods such as spin coating methods, casting methods, dipping methods, plate-based printing methods such as relief printing, intaglio printing, offset printing, lithographic printing, relief reversal offset printing, screen printing and gravure printing, and plateless printing methods such as inkjet methods. In a case in which the organic layer is formed by a coating method, the organic layer (coating layer) obtained following coating may be dried using a hotplate or an oven to remove the solvent.

The charge transport polymers I and II each have a polymerizable functional group. In such cases, the charge transport polymer can be subjected to a polymerization reaction using light irradiation or a heat treatment or the like, thereby changing the solubility of the organic layer. By stacking organic layers having changed solubility levels, an organic electronic element having a multilayer structure can be formed with ease. Reference may also be made to WO 2010/140553 in relation to the method used for forming the organic layer.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

### <Organic Electronic Element>

An organic electronic element according to one embodiment of the present invention includes at least one or more organic layer of the embodiment described above. Examples of the organic electronic element include an organic EL element, an organic photoelectric conversion element, and an organic transistor. The organic electronic element preferably has at least a structure in which an organic layer is disposed between a pair of electrodes.

### <Organic EL Element>

An organic EL element according to one embodiment of the present invention includes at least one or more of the organic layers of the embodiment described above. The organic EL element typically includes a light-emitting layer, an anode, a cathode and a substrate, and if necessary, may also include other functional layers such as a hole injection layer, electron injection layer, hole transport layer and electron transport layer. Each layer may be formed using a vapor deposition method, or using a coating method. The organic EL element preferably includes the aforementioned organic layer as the light-emitting layer or as another functional layer, more preferably includes the organic layer as a functional layer, and further preferably includes the organic layer as at least one of a hole injection layer and a hole transport layer.

FIG. 1 is a cross-sectional schematic view illustrating one embodiment of the organic EL element. The organic EL element in FIG. 1 is an element with a multilayer structure, and has a substrate 8, an anode 2, a hole injection layer 3, a hole transport layer 6, a light-emitting layer 1, an electron transport layer 7, an electron injection layer 5 and a cathode 4 provided in that order. Each of these layers is described below.

### [Light-Emitting Layer]

Examples of the materials that can be used for the light-emitting layer include low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoqionoline)iridium) which emit red light. Specific examples of Pt complexes include PtOEP (2,3,7,8,12,13,17,18-octaethyl-21H,23H-porphine-platinum) which emits red light.

In a case in which the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material of the aforementioned embodiment, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Injection Layer, Hole Transport Layer]

The organic layer formed using the organic electronic material described above is preferably used as at least one of a hole injection layer and a hole transport layer, and is more preferably used as at least a hole transport layer. As described above, by using an ink composition containing the organic electronic material, these types of layers can be formed with ease.

In a case in which the organic EL element has a structure in which the organic layer formed using the organic electronic material described above is used as a hole transport layer, and the element also has a hole injection layer, then a conventional material may be used for the hole injection layer. In a case in which the organic EL element has a structure in which the organic layer formed using the organic electronic material described above is used as a hole injection layer, and the element also has a hole transport layer, then a conventional material may be used for the hole transport layer.

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring (such as naphthalene and perylene) tetracarboxylic acid anhydrides, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. The organic electronic material of the embodiment described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode material. Examples of the other materials include oxides (for example, ITO: indium oxide/tin oxide, and conductive polymers (for example, polythiophene-polystyrene sulfonate mixtures (PEDOT:PSS)).

### [Substrate]

Glass and plastics and the like can be used as the substrate. The substrate is preferably transparent. A flexible substrate having flexibility is preferred. Quartz glass and light-transmitting resin films and the like can be used particularly favorably.

Examples of the resin films include films formed with, for example, polyethylene terephthalate, polyethylene naphthalate, polyethersulfone, polyetherimide, polyetheretherketone, polyphenylene sulfide, polyarylate, polyimide, polycarbonate, cellulose triacetate, cellulose acetate propionate, and/or the like.

In those cases where a resin film is used, an inorganic substance such as silicon oxide or silicon nitride may be coated onto the resin film to inhibit the transmission of water vapor and oxygen and the like.

### [Encapsulation]

The organic EL element may be encapsulated to reduce the effect of the outside atmosphere and extend the life of the element. Materials that can be used for the encapsulation include, but are not limited to, glass, plastic films such as epoxy resins, acrylic resins, polyethylene terephthalate and polyethylene naphthalate, and inorganic substances such as silicon oxide and silicon nitride.

There are also no particular limitations on the encapsulation method, and conventional methods may be used.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element involves using a plurality of light-emitting materials to emit a plurality of colors simultaneously, and then mixing the emitted colors to obtain a white light emission. There are no particular limitations on the combination of the plurality of emission colors, and examples include combinations that include three maximum emission wavelengths for blue, green and red, and combinations that include two maximum emission wavelengths such as blue and yellow, or yellowish green and orange. Control of the emission color can be achieved by appropriate adjustment of the types and amounts of the light-emitting materials.

### <Display Element, Illumination Device, Display Device>

A display element according to one embodiment of the present invention includes the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, an illumination device according to one embodiment of the present invention includes the organic EL element of an embodiment of the present invention. Moreover, a display device according to an embodiment of the present invention includes the illumination device and a liquid crystal element as a display unit. For example, the display device may be a device that uses the illumination device according to an embodiment of the present invention as a backlight, and uses a conventional liquid crystal element as the display unit, namely a liquid crystal display device.

Embodiments of the present invention include the following. However, the present invention is not limited to the embodiments described below.
<1> An organic electronic material comprising a charge transport polymer including at least one structure selected from the group consisting of a structure represented by the following formula (1), a structure represented by the following formula (2), and a structure represented by the following formula (3): 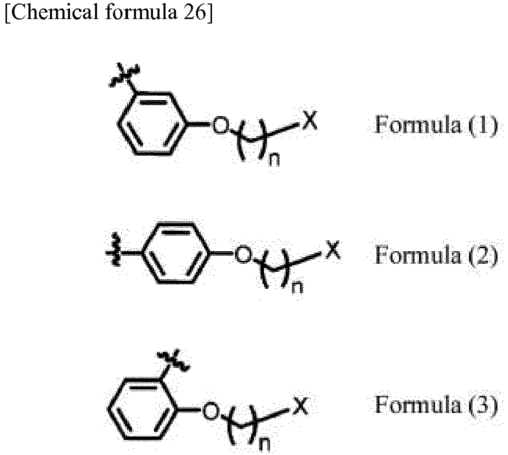 wherein in formulas (1) to (3), X represents a polymerizable functional group selected from the group consisting of a substituted or unsubstituted oxetane group and a substituted or unsubstituted vinyl group, and n represents an integer of 1 to 12.
<2> The organic electronic material according to <1>, wherein the charge transport polymer has at least one structure selected from the group consisting of a structure represented by the (1), a structure represented by the formula (2) and a structure represented by the formula (3) at a terminal.
<3> An organic electronic material comprising a charge transport polymer including at least one structure selected from the group consisting of a structure represented by the following formula (1a), a structure represented by the following formula (2a), and a structure represented by the following formula (3a): 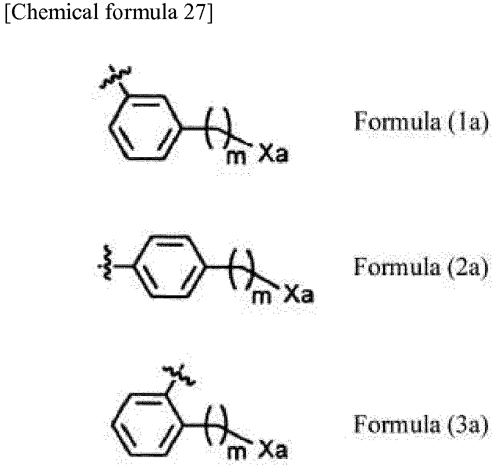 wherein in formulas (1a) to (3a), Xa represents a polymerizable functional group, and m represents an integer of 1 to 30.
<4> The organic electronic material according to < 3>, wherein the charge transport polymer has at least one structure selected from the group consisting of a structure represented by the formula (1a), a structure represented by the formula (2a) and a structure represented by the formula (3a) at a terminal.
<5> The organic electronic material according to any one of <1> to <4>, wherein the charge transport polymer has a structure that branches in three or more directions, and includes a trivalent or higher valent structural unit containing a structure selected from the group consisting of a substituted or unsubstituted aromatic amine structure, a substituted or unsubstituted carbazole structure, a substituted or unsubstituted thiophene structure, a substituted or unsubstituted bithiophene structure, a substituted or unsubstituted benzene structure, a substituted or unsubstituted polycyclic aromatic structure in which a plurality of benzene rings are condensed, and a substituted or unsubstituted fluorene structure.
<6> The organic electronic material according to any one of <1> to <5>, wherein the charge transport polymer includes a divalent structural unit containing a structure selected from the group consisting of a substituted or unsubstituted aromatic amine structure, a substituted or unsubstituted carbazole structure, a substituted or unsubstituted thiophene structure, a substituted or unsubstituted bithiophene structure, a substituted or unsubstituted benzene structure, a substituted or unsubstituted polycyclic aromatic structure in which a plurality of benzene rings are condensed, and a substituted or unsubstituted fluorene structure.
<7> The organic electronic material according to any one of <1> to <6>, wherein the charge transport polymer is a hole transport material.
<8> The organic electronic material according to any one of <1> to <7>, further comprising a polymerization initiator.
<9> The organic electronic material according to <8>, wherein the polymerization initiator comprises a cationic polymerization initiator.
<10> The organic electronic material according to <9>, wherein the cationic polymerization initiator comprises an onium salt.
<11> An organic layer formed using the organic electronic material according to any one of <1> to <10>.
<12> An organic electronic element comprising the organic layer according to <11>.
<13> An organic electroluminescent element comprising the organic layer according to <11>.
<14> The organic electroluminescent element according to <13>, comprising a light-emitting layer comprising a phosphorescent material.
<15> The organic electroluminescent element according to <13>, comprising a light-emitting layer comprising a delayed fluorescent material.
<16> The organic electroluminescent element according to any one of <13> to <15>, further comprising a flexible substrate.
<17> The organic electroluminescent element according to any one of <13> to <15>, further comprising a resin film substrate.
<18> A display element comprising the organic electroluminescent element according to any one of <13> to <17>.
<19> An illumination device comprising the organic electroluminescent element according to any one of <13> to <17>.
<20> A display device comprising the illumination device according to <19>, and a liquid crystal element as a display unit.

The entire contents of Japanese Patent Application No. 2016-217367 and the entire contents of Japanese Patent Application No. 2016-145263 are incorporated in the present description by reference herein.

### EXAMPLES

The present invention is described below in further detail using a series of examples, but the present invention is not limited by the following examples. Unless specifically stated otherwise, "%" means "% by mass".

### <Preparation of Pd Catalyst>

In a glove box under a nitrogen atmosphere and at room temperature, tris(dibenzylideneacetone)dipalladium (73.2 mg, 80 µmol) was weighed into a sample tube, anisole (15 ml) was added, and the resulting mixture was agitated for 30 minutes. Similarly, tris(t-butyl)phosphine (129.6 mg, 640 µmol) was weighed into a sample tube, anisole (5 ml) was added, and the resulting mixture was agitated for 5 minutes. The two solutions were then mixed together and stirred for 30 minutes at room temperature to obtain a catalyst solution. All the solvents used in the catalyst preparation were deaerated by nitrogen bubbling for at least 30 minutes prior to use.

### 1. First Examples and Comparative Examples

### <Synthesis of Charge Transport Polymers>

The charge transport polymers shown in Table 1 were synthesized using the following procedure. A bromo monomer shown below, a boronic acid monomer shown below, a polymerizable monomer shown below and a terminal monomer shown below were combined as shown in Table 1, thus synthesizing a series of polymers. A three-neck round-bottom flask was charged with the boronic acid monomer (4.0 mmol), the bromo monomer (5.0 mmol), the polymerizable monomer (in the case of 100% of the polymerizable monomer: 2.0 mmol, and in the case of 50% of the polymerizable monomer: 1.0 mmol), the terminal monomer (in the case of 100% of the polymerizable monomer: 0 mmol, and in the case of 50% of the polymerizable monomer: 1.0 mmol) and anisole (20 mL), and the prepared Pd catalyst solution (7.5 mL) was then added. After stirring for 30 minutes, a 10% aqueous solution of tetraethylammonium hydroxide (20 mL) was added. The resulting mixture was then heated and refluxed for 2 hours. All the operations up to this point were conducted under a stream of nitrogen. Further, all of the solvents were deaerated by nitrogen bubbling for at least 30 minutes prior to use.

### [Bromo Monomers]

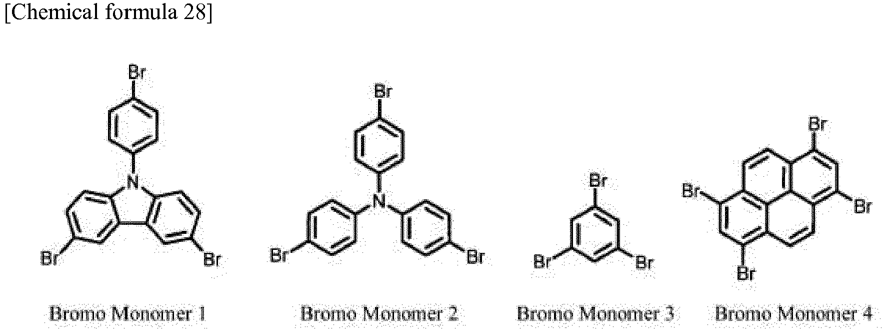

### [Boronic Acid Monomers]

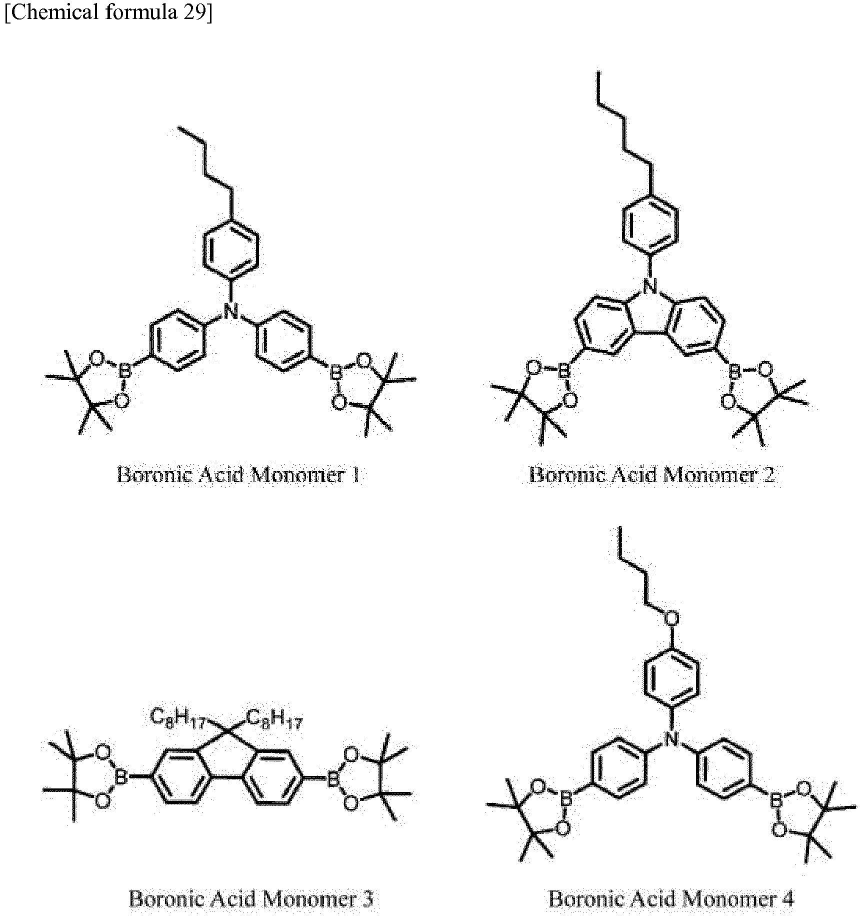

### [Polymerizable Monomers]

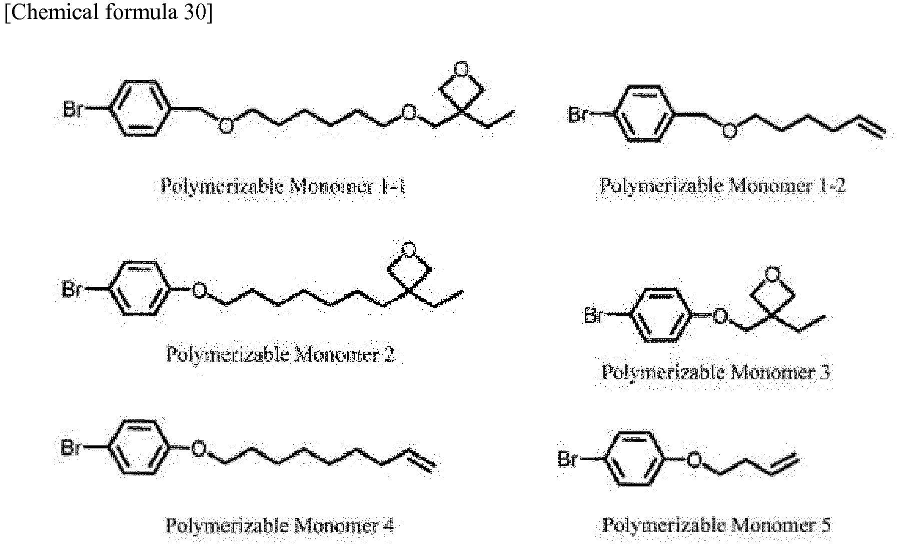

### [Terminal Monomer]

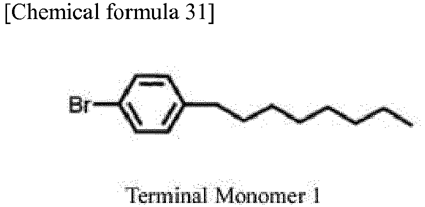

Purification of the charge transport polymers shown in Table 1 was performed using the following procedure. Following completion of the reaction, the organic layer was washed with water, and the organic layer was then poured into methanol-water (9:1). The resulting precipitate was collected by filtration. A washing process of stirring the collected solid in ethyl acetate and then performing filtration to collect the solid was repeated three times. The washed precipitate was dissolved in toluene, and re-precipitated from methanol. The resulting precipitate was dried thoroughly and then dissolved in toluene to form a 10% polymer solution. A scavenger ("Triphenylphosphine, polymer-bound on styrene-divinylbenzene copolymer", manufactured by Strem Chemicals Inc.) was added to the solution in a mass equal to the mass of the polymer, and the resulting mixture was stirred at room temperature for at least 5 hours. Subsequently, the scavenger was removed by filtration through a polytetrafluoroethylene filter having a pore size of 0.2 µm (DISMIC 25JP020AN), and the filtrate was mixed with methanol to re-precipitate the polymer. The polymer was collected by filtration and dried under vacuum in a desiccator to obtain a charge transport polymer from which low-molecular weight components had not been removed.

The weight average molecular weight Mw and the number average molecular weight Mn of the obtained polymer were determined by measurement by GPC. The GPC measurement conditions were as follows. The obtained values are shown in Table 2.
Apparatus: High-performance liquid chromatograph "Prominence", manufactured by Shimadzu Corporation
   Feed pump (LC-20AD)
   Degassing unit (DGU-20A)
   Autosampler (SIL-20AHT)
   Column oven (CTO-20A)
   PDA detector (SPD-M20A)
   Refractive index detector (RID-20A)
Columns: Gelpack (a registered trademark)
   GL-A160S (product number: 686-1J27)
   GL-A150S (product number: 685-1J27)
   manufactured by Hitachi Chemical Co., Ltd.
Eluent: Tetrahydrofuran (THF) (for HPLC, contains stabilizers), manufactured by Wako Pure Chemical Industries, Ltd.
Flow rate: 1 mL/min
Column temperature: 40°C
Detection wavelength: 254 nm
Molecular weight standards: Standard Polystyrene Kit PStQuick A/B/C, manufactured by Tosoh Corporation

**[Table 1]**

| Charge transport polymer | Bromo monomer | Boronic acid monomer | Polymerizable monomer | Terminal monomer |
|---|---|---|---|---|
| 1-0 | Bromo monomer 1 | Boronic acid monomer 1 | Polymerizable monomer 1-1 50% | Terminal 1 monomer |
| 1-1 | | | Polymerizable monomer 2 100% | |
| 1-2 | | | Polymerizable monomer 2 50% | |
| 2-1 | | | Polymerizable monomer 3 100% | |
| 2-2 | | | Polymerizable monomer 3 50% | |
| 3-0 | | | Polymerizable monomer 1-2 100% | |
| 3-1 | | | Polymerizable monomer 4 100% | |
| 3-2 | | | Polymerizable monomer 4 50% | |
| 4-1 | | | Polymerizable monomer 5 100% | |
| 4-2 | | | Polymerizable monomer 5 50% | |
| 5-0 | | Boronic acid monomer 2 | Polymerizable monomer 1-1 50% | |
| 5-1 | | | Polymerizable monomer 2 50% | |
| 6-1 | | | Polymerizable monomer 3 50% | |
| 7-0 | | | Polymerizable monomer 1-2 50% | |
| 7-1 | | | Polymerizable monomer 4 50% | |
| 8-1 | | | Polymerizable monomer 5 50% | |
| 9-0 | | Boronic acid monomer 3 | Polymerizable monomer 1-1 50% | |
| 9-1 | | | Polymerizable monomer 2 50% | |
| 10-1 | | | Polymerizable monomer 3 50% | |
| 11-0 | | | Polymerizable monomer 1-2 50% | |
| 11-1 | | | Polymerizable monomer 4 50% | |
| 12-1 | | | Polymerizable monomer 5 50% | |
| 13-0 | Bromo monomer 1 | Boronic acid monomer 4 | Polymerizable monomer 1-1 50% | |
| 13-1 | | | Polymerizable monomer 2 50% | |
| 14-1 | | | Polymerizable monomer 3 50% | |
| 15-0 | | | Polymerizable monomer 1-2 50% | |
| 15-1 | | | Polymerizable monomer 4 50% | |
| 16-1 | | | Polymerizable monomer 5 50% | |
| 17-0 | Bromo monomer 2 | Boronic acid monomer 1 | Polymerizable monomer 1-1 50% | |
| 17-1 | | | Polymerizable monomer 2 50% | |
| 18-1 | | | Polymerizable monomer 3 50% | |
| 19-0 | | | Polymerizable monomer 1-2 50% | |
| 19-1 | | | Polymerizable monomer 4 50% | |
| 20-1 | | | Polymerizable monomer 5 50% | |
| 21-0 | Bromo monomer 3 | Boronic acid monomer 1 | Polymerizable monomer 1-1 50% | |
| 21-1 | | | Polymerizable monomer 2 50% | |
| 22-1 | | | Polymerizable monomer 3 50% | |
| 23-0 | | | Polymerizable monomer 1-2 50% | |
| 23-1 | | | Polymerizable monomer 4 50% | |
| 24-1 | | | Polymerizable monomer 5 50% | |
| 25-0 | Bromo monomer 4 | Boronic acid monomer 1 | Polymerizable monomer 1-1 50% | |
| 25-1 | | | Polymerizable monomer 2 50% | |
| 26-1 | | | Polymerizable monomer 3 50% | |
| 27-0 | | | Polymerizable monomer 1-2 50% | |
| 27-1 | | | Polymerizable monomer 4 50% | |
| 28-1 | | | Polymerizable monomer 5 50% | |

**[Table 2]**

| Charge transport polymer | Mn | Mw |
|---|---|---|
| 1-0 | 26,700 | 89,700 |
| 1-1 | 32,600 | 98,700 |
| 1-2 | 21,500 | 69,800 |
| 2-1 | 36,900 | 78,600 |
| 2-2 | 25,400 | 74,600 |
| 3-0 | 32,300 | 96,800 |
| 3-1 | 29,800 | 88,700 |
| 3-2 | 36,500 | 67,800 |
| 4-1 | 34,700 | 88,700 |
| 4-2 | 29,800 | 98,700 |
| 5-0 | 37,100 | 99,800 |
| 5-1 | 39,600 | 92,400 |
| 6-1 | 39,800 | 88,400 |
| 7-0 | 39,900 | 84,200 |
| 7-1 | 45,900 | 90,500 |
| 8-1 | 36,800 | 80,200 |
| 9-0 | 36,400 | 74,900 |
| 9-1 | 43,100 | 88,900 |
| 10-1 | 41,200 | 79,500 |
| 11-0 | 29,200 | 78,200 |
| 11-1 | 32,500 | 96,300 |
| 12-1 | 39,500 | 94,100 |
| 13-0 | 32,600 | 78,100 |
| 13-1 | 37,800 | 75,900 |
| 14-1 | 34,900 | 78,600 |
| 15-0 | 32,200 | 90,100 |
| 15-1 | 28,500 | 89,700 |
| 16-1 | 24,100 | 77,800 |
| 17-0 | 41,200 | 96,300 |
| 17-1 | 39,800 | 78,900 |
| 18-1 | 36,900 | 85,600 |
| 19-0 | 31,100 | 74,100 |
| 19-1 | 26,500 | 84,900 |
| 20-1 | 27,800 | 79,100 |
| 21-0 | 32,100 | 70,900 |
| 21-1 | 33,200 | 80,900 |
| 22-1 | 45,200 | 79,900 |
| 23-0 | 32,500 | 75,900 |
| 23-1 | 23,400 | 82,100 |
| 24-1 | 28,600 | 87,500 |
| 25-0 | 29,100 | 73,600 |
| 25-1 | 23,400 | 70,900 |
| 26-1 | 22,900 | 64,900 |
| 27-0 | 27,800 | 61,100 |
| 27-1 | 23,100 | 59,800 |
| 28-1 | 28,400 | 57,600 |

### <Production of Organic EL Elements>

Organic EL elements shown for Comparative Examples 1 to 14 and Examples 1 to 32 in Table 3 were produced using the following procedure. A PEDOT:PSS dispersion (AI4083 LVW142, manufactured by H.C. Starck-V-Tech Ltd.) was applied by spin coating at a revolution rate of 1,500 min⁻¹ to a glass substrate on which ITO had been patterned with a width of 1.6 mm, and the applied coating was dried by heating on a hotplate in the open air at 200°C for 10 minutes, thus forming a hole injection layer (40 nm). Subsequent experiments were performed under a dry nitrogen atmosphere.

The charge transport polymer (4.5 mg) shown in Table 3, an ionic compound 1 shown below (0.13 mg) and toluene (1.2 mL) were mixed together to prepare an ink composition for forming a hole transport layer. This ink composition was spin-coated onto the hole injection layer obtained above at a revolution rate of 3,000 min⁻¹, and was then cured by heating on a hotplate at 120°C for 10 minutes, thus forming a hole transport layer (40 nm).

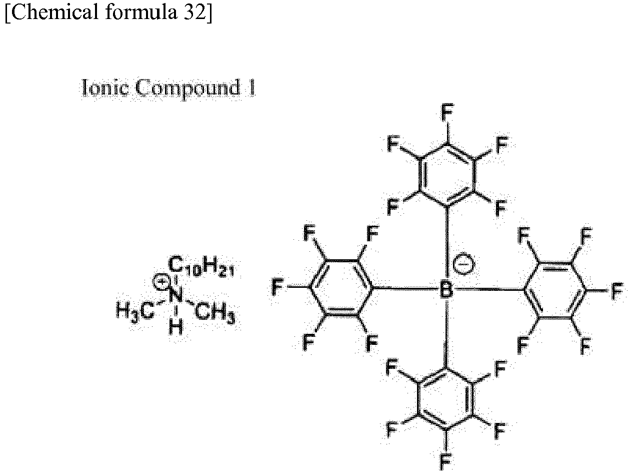

The thus obtained glass substrate was transferred into a vacuum deposition apparatus, and layers of CBP:Ir(ppy)₃ (94:6, 30 nm), BAlq (10 nm), Alq₃ (30 nm), LiF (0.8 nm) and Al (100 nm) were formed by vapor deposition in that order on top of the hole transport layer, thereby stacking a light-emitting layer, a hole blocking layer, an electron transport layer, an electron injection layer and a cathode respectively.

Following formation of the electrode, the layered glass substrate was transferred under a dry nitrogen atmosphere without exposure to the external atmosphere, and was encapsulated by bonding, using a photocurable epoxy resin, to an encapsulating glass having a countersink of 0.4 mm formed in an alkali-free glass with a thickness of 0.7 mm, thus completing production of a polymeric organic EL element having a multilayer structure.

A voltage was applied to each of the organic EL elements shown for Comparative Examples 1 to 14 and Examples 1 to 32 in Table 3, and the light emission performance was evaluated. The results confirmed a green light emission from each element. For each element, the drive voltage and emission efficiency at a luminance of 1,000 cd/m², and the emission lifespan (luminance half-life) when the initial luminance was 3,000 cd/m² were measured. The measurement results are shown in Table 3.

**[Table 3]**

| Comparative Examples and Examples | Charge transport polymer | Drive voltage (V) | Emission efficiency (cd/A) | Emission lifespan (h) |
|---|---|---|---|---|
| Comparative Example 1 | 1-0 | 7.2 | 14.4 | 45 |
| Example 1 | 1-1 | 7.0 | 26.2 | 98 |
| Example 2 | 1-2 | 7.2 | 23.4 | 78 |
| Example 3 | 2-1 | 7.1 | 24.6 | 110 |
| Example 4 | 2-2 | 6.9 | 25.1 | 87 |
| Comparative Example 2 | 3-0 | 7.0 | 16.3 | 51 |
| Example 5 | 3-1 | 6.8 | 26.3 | 76 |
| Example 6 | 3-2 | 7.3 | 24.4 | 69 |
| Example 7 | 4-1 | 7.4 | 25.9 | 120 |
| Example 8 | 4-2 | 7.2 | 25.6 | 96 |
| Comparative Example 3 | 5-0 | 7.6 | 16.3 | 29 |
| Example 9 | 5-1 | 7.9 | 28.3 | 80 |
| Example 10 | 6-1 | 8.1 | 29.8 | 66 |
| Comparative Example 4 | 7-0 | 8.2 | 12.1 | 15 |
| Example 11 | 7-1 | 8.2 | 25.1 | 78 |
| Example 12 | 8-1 | 7.6 | 27.3 | 69 |
| Comparative Example 5 | 9-0 | 7.2 | 15.9 | 32 |
| Example 13 | 9-1 | 7.3 | 24.3 | 92 |
| Example 14 | 10-1 | 7.3 | 23.9 | 74 |
| Comparative Example 6 | 11-0 | 7.2 | 17.1 | 29 |
| Example 15 | 11-1 | 7.4 | 23.3 | 88 |
| Example 16 | 12-1 | 7.2 | 23.4 | 77 |
| Comparative Example 7 | 13-0 | 6.6 | 15.5 | 56 |
| Example 17 | 13-1 | 6.5 | 21.1 | 102 |
| Example 18 | 14-1 | 6.4 | 20.0 | 116 |
| Comparative Example 8 | 15-0 | 6.6 | 14.9 | 64 |
| Example 19 | 15-1 | 6.5 | 19.3 | 142 |
| Example 20 | 16-1 | 6.6 | 21.0 | 114 |
| Comparative Example 9 | 17-0 | 6.8 | 13.3 | 53 |
| Example 21 | 17-1 | 6.8 | 20.9 | 146 |
| Example 22 | 18-1 | 6.6 | 21.0 | 120 |
| Comparative Example 10 | 19-0 | 6.5 | 14.3 | 60 |
| Example 23 | 19-1 | 6.4 | 21.1 | 136 |
| Example 24 | 20-1 | 6.4 | 23.7 | 111 |
| Comparative Example 11 | 21-0 | 8.2 | 19.8 | 43 |
| Example 25 | 21-1 | 8.0 | 28.8 | 76 |
| Example 26 | 22-1 | 7.9 | 29.2 | 63 |
| Comparative Example 12 | 23-0 | 8.2 | 17.7 | 41 |
| Example 27 | 23-1 | 8.2 | 27.2 | 92 |
| Example 28 | 24-1 | 8.1 | 28.4 | 88 |
| Comparative Example 13 | 25-0 | 7.6 | 18.0 | 52 |
| Example 29 | 25-1 | 7.6 | 25.6 | 114 |
| Example 30 | 26-1 | 7.7 | 25.1 | 123 |
| Comparative Example 14 | 27-0 | 7.5 | 17.9 | 61 |
| Example 31 | 27-1 | 7.9 | 26.2 | 128 |
| Example 32 | 28-1 | 7.7 | 26.4 | 110 |

### 2. Second Examples and Comparative Examples

### <Synthesis of Charge Transport Polymers>

The charge transport polymers shown in Table 4 were synthesized using the following procedure. A bromo monomer shown below, a boronic acid monomer shown below, a polymerizable monomer shown below and a terminal monomer shown below were combined as shown in Table 4, thus synthesizing a series of polymers. A three-neck round-bottom flask was charged with the boronic acid monomer (4.0 mmol), the bromo monomer (5.0 mmol), the polymerizable monomer (in the case of 100% of the polymerizable monomer: 2.0 mmol, and in the case of 50% of the polymerizable monomer: 1.0 mmol), the terminal monomer (in the case of 100% of the polymerizable monomer: 0 mmol, in the case of 50% of the polymerizable monomer: 1.0 mmol, and in the case of 25% of the polymerizable monomer: 1.5 mmol) and anisole (20 mL), and the aforementioned prepared Pd catalyst solution (7.5 mL) was then added. After stirring for 30 minutes, a 10% aqueous solution of tetraethylammonium hydroxide (20 mL) was added. The resulting mixture was then heated and refluxed for 2 hours. All the operations up to this point were conducted under a stream of nitrogen. Further, all of the solvents were deaerated by nitrogen bubbling for at least 30 minutes prior to use.

### [Bromo Monomers]

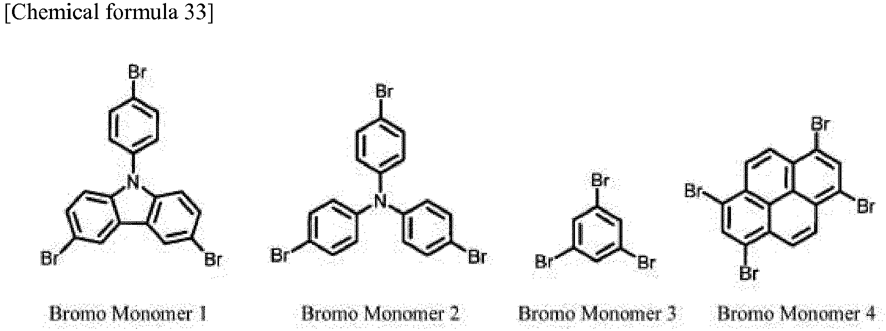

### [Boronic Acid Monomers]

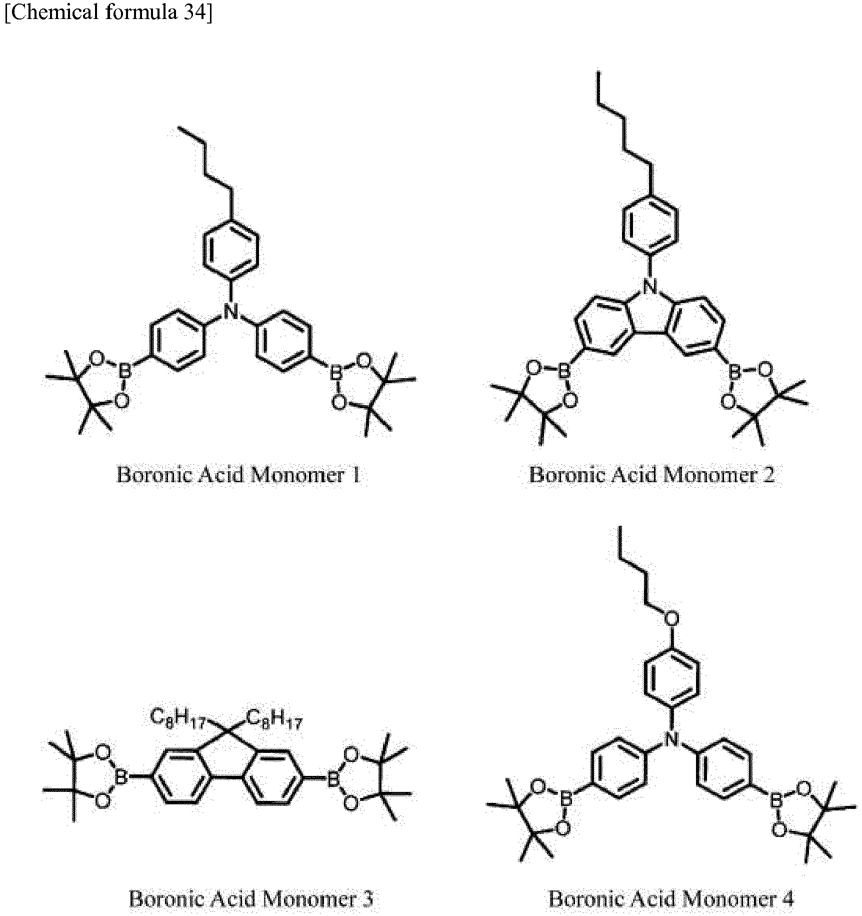

### [Polymerizable Monomers]

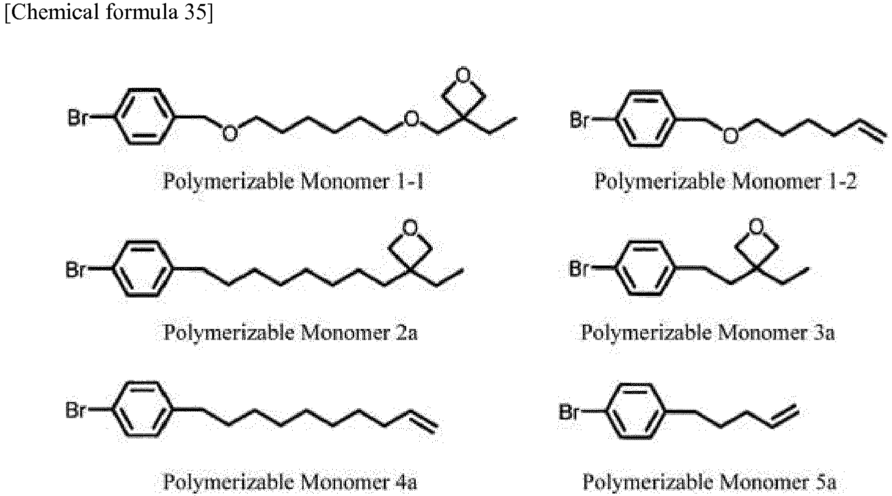

### [Terminal Monomer]

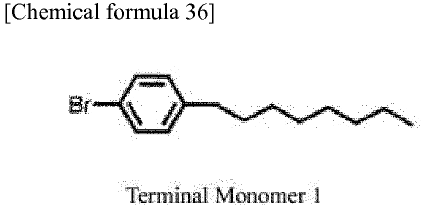

Purification of the charge transport polymers shown in Table 4 was performed using the following procedure. Following completion of the reaction, the organic layer was washed with water, and the organic layer was then poured into methanol-water (9:1). The resulting precipitate was collected by filtration. A washing process of stirring the collected solid in ethyl acetate and then performing filtration to collect the solid was repeated three times. The washed precipitate was dissolved in toluene, and re-precipitated from methanol. The resulting precipitate was dried thoroughly and then dissolved in toluene to form a 10% polymer solution. A scavenger ("Triphenylphosphine, polymer-bound on styrene-divinylbenzene copolymer", manufactured by Strem Chemicals Inc.) was added to the solution in a mass equal to the mass of the polymer, and the resulting mixture was stirred at room temperature for at least 5 hours. Subsequently, the scavenger was removed by filtration through a polytetrafluoroethylene filter having a pore size of 0.2 µm (DISMIC 25JP020AN), and the filtrate was mixed with methanol to re-precipitate the polymer. The polymer was collected by filtration and dried under vacuum in a desiccator to obtain a charge transport polymer from which low-molecular weight components had not been removed.

The weight average molecular weight Mw and the number average molecular weight Mn of the obtained polymer were determined by measurement by GPC. The GPC measurement conditions were the same as those described above for the first examples and comparative examples. The obtained values are shown in Table 5.

**[Table 4]**

| Charge transport polymer | Bromo monomer | Boronic acid monomer | Polymerizable monomer | Terminal monomer |
|---|---|---|---|---|
| 1-0a | Bromo monomer 1 | Boronic acid monomer 1 | Polymerizable monomer 1-1 50% | Terminal monomer 1 |
| 1-1a | | | Polymerizable monomer 2a 100% | |
| 1-2a | | | Polymerizable monomer 2a 50% | |
| 2-1a | | | Polymerizable monomer 3a 100% | |
| 2-2a | | | Polymerizable monomer 3a 50% | |
| 3-0a | | | Polymerizable monomer 1-2 50% | |
| 3-1a | | | Polymerizable monomer 4a 100% | |
| 3-2a | | | Polymerizable monomer 4a 50% | |
| 4-1a | | | Polymerizable monomer 5a 100% | |
| 4-2a | | | Polymerizable monomer 5a 50% | |
| 5-0a | | Boronic acid monomer 2 | Polymerizable monomer 1-1 50% | |
| 5-1a | | | Polymerizable monomer 2a 50% | |
| 6-1a | | | Polymerizable monomer 3a 50% | |
| 7-0a | | | Polymerizable monomer 1-2 50% | |
| 7-1a | | | Polymerizable monomer 4a 50% | |
| 8-1a | | | Polymerizable monomer 5a 50% | |
| 9-0a | | Boronic acid monomer 3 | Polymerizable monomer 1-1 50% | |
| 9-1a | | | Polymerizable monomer 2a 50% | |
| 10-1a | | | Polymerizable monomer 3a 50% | |
| 11-0a | | | Polymerizable monomer 1-2 50% | |
| 11-1a | | | Polymerizable monomer 4a 50% | |
| 12-1a | | | Polymerizable monomer 5a 50% | |
| 13-0a | | Boronic acid monomer 4 | Polymerizable monomer 1-1 50% | |
| 13-1a | | | Polymerizable monomer 2a 50% | |
| 14-1a | | | Polymerizable monomer 3a 50% | |
| 15-0a | | | Polymerizable monomer 1-2 50% | |
| 15-1a | | | Polymerizable monomer 4a 50% | |
| 16-1a | | | Polymerizable monomer 5a 50% | |
| 17-0a | Bromo monomer 2 | Boronic acid monomer 1 | Polymerizable monomer 1-1 50% | |
| 17-1a | | | Polymerizable monomer 2a 50% | |
| 18-1a | | | Polymerizable monomer 3a 50% | |
| 19-0a | | | Polymerizable monomer 1-2 50% | |
| 19-1a | | | Polymerizable monomer 4a 50% | |
| 20-1a | | | Polymerizable monomer 5a 50% | |
| 21-0a | Bromo monomer 3 | Boronic acid monomer 1 | Polymerizable monomer 1-1 50% | |
| 21-1a | | | Polymerizable monomer 2a 50% | |
| 22-1a | | | Polymerizable monomer 3a 50% | |
| 23-0a | | | Polymerizable monomer 1-2 50% | |
| 23-1a | | | Polymerizable monomer 4a 50% | |
| 24-1a | | | Polymerizable monomer 5a 50% | |
| 25-0a | Bromo monomer 4 | Boronic acid monomer 1 | Polymerizable monomer 1-1 50% | |
| 25-1a | | | Polymerizable monomer 2a 50% | |
| 26-1a | | | Polymerizable monomer 3a 50% | |
| 27-0a | | | Polymerizable monomer 1-2 50% | |
| 27-1a | | | Polymerizable monomer 4a 50% | |
| 28-1a | | | Polymerizable monomer 5a 50% | |

**[Table 5]**

| Charge transport polymer | Number average molecular weight Mn | Weight average molecular weight Mw |
|---|---|---|
| 1-0a | 26,700 | 89,700 |
| 1-1a | 36,700 | 98,500 |
| 1-2a | 33,700 | 96,900 |
| 2-1a | 28,100 | 86,000 |
| 2-2a | 38,300 | 92,800 |
| 3-0a | 32,300 | 96,800 |
| 3-1a | 38,600 | 92,200 |
| 3-2a | 32,700 | 94,700 |
| 4-1a | 30,300 | 95,900 |
| 4-2a | 30,600 | 89,700 |
| 5-0a | 37,100 | 99,800 |
| 5-1a | 36,000 | 75,800 |
| 6-1a | 28,500 | 86,900 |
| 7-0a | 39,900 | 84,200 |
| 7-1a | 30,900 | 96,200 |
| 8-1a | 37,600 | 81,800 |
| 9-0a | 36,400 | 74,900 |
| 9-1a | 30,500 | 87,800 |
| 10-1a | 38,400 | 79,000 |
| 11-0a | 29,200 | 78,200 |
| 11-1a | 30,700 | 88,700 |
| 12-1a | 36,500 | 80,700 |
| 13-0a | 29,200 | 78,200 |
| 13-1a | 31,700 | 98,100 |
| 14-1a | 38,200 | 82,100 |
| 15-0a | 32,200 | 90,100 |
| 15-1a | 28,500 | 76,100 |
| 16-1a | 39,100 | 87,800 |
| 17-0a | 41,200 | 96,300 |
| 17-1a | 29,300 | 95,200 |
| 18-1a | 28,400 | 90,400 |
| 19-0a | 31,100 | 74,100 |
| 19-1a | 35,700 | 78,100 |
| 20-1a | 36,600 | 79,000 |
| 21-0a | 32,100 | 70,900 |
| 21-1a | 35,900 | 88,300 |
| 22-1a | 40,000 | 81,700 |
| 23-0a | 32,500 | 75,900 |
| 23-1a | 31,900 | 93,500 |
| 24-1a | 38,600 | 82,800 |
| 25-0a | 29,100 | 73,600 |
| 25-1a | 32,100 | 96,900 |
| 26-1a | 36,600 | 89,700 |
| 27-0a | 27,800 | 61,100 |
| 27-1a | 24,000 | 68,500 |
| 28-1a | 22,800 | 55,900 |

### <Production of Organic EL Elements>

Organic EL elements shown for Comparative Examples 1a to 14a and Examples 1a to 32a in Table 6 were produced using the following procedure.

A PEDOT:PSS dispersion (AI4083 LVW142, manufactured by H.C. Starck-V-Tech Ltd.) was applied by spin coating at a revolution rate of 1,500 min⁻¹ to a glass substrate on which ITO had been patterned with a width of 1.6 mm, and the applied coating was dried by heating on a hotplate in the open air at 200°C for 10 minutes, thus forming a hole injection layer (40 nm). Subsequent experiments were performed under a dry nitrogen atmosphere.

The charge transport polymer (4.5 mg) shown in Table 6, an ionic compound 1 shown below (0.13 mg) and toluene (1.2 mL) were mixed together to prepare an ink composition for forming a hole transport layer. This ink composition was spin-coated onto the hole injection layer obtained above at a revolution rate of 3,000 min⁻¹, and was then cured by heating on a hotplate at 120°C for 10 minutes, thus forming a hole transport layer (40 nm).

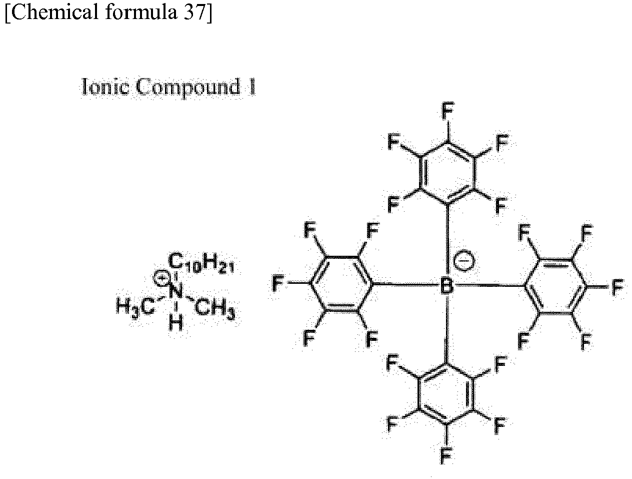

The thus obtained glass substrate was transferred into a vacuum deposition apparatus, and layers of CBP:Ir(ppy)₃ (94:6, 30 nm), BAlq (10 nm), Alq₃ (30 nm), LiF (0.8 nm) and Al (100 nm) were formed by vapor deposition in that order on top of the hole transport layer, thereby stacking a light-emitting layer, a hole blocking layer, an electron transport layer, an electron injection layer and a cathode respectively.

Following formation of the electrode, the layered glass substrate was transferred under a dry nitrogen atmosphere without exposure to the external atmosphere, and was encapsulated by bonding, using a photocurable epoxy resin, to an encapsulating glass having a countersink of 0.4 mm formed in an alkali-free glass with a thickness of 0.7 mm, thus completing production of a polymeric organic EL element having a multilayer structure.

A voltage was applied to each of the organic EL elements shown for Comparative Examples 1a to 14a and Examples 1a to 32a in Table 6, and the light emission performance was evaluated. The results confirmed a green light emission from each element. For each element, the drive voltage and emission efficiency at a luminance of 1,000 cd/m², and the emission lifespan (luminance half-life) when the initial luminance was 3,000 cd/m² were measured. The measurement results are shown in Table 6.

**[Table 6]**

| Comparative Examples and Examples | Charge transport polymer | Drive voltage (V) | Emission efficiency (cd/A) | Emission lifespan (h) |
|---|---|---|---|---|
| Comparative Example 1a | 1-0a | 7.2 | 14.4 | 45 |
| Example 1a | 1-1a | 7.0 | 27.0 | 102 |
| Example 2a | 1-2a | 7.1 | 25.1 | 90 |
| Example 3a | 2-1a | 6.9 | 26.1 | 126 |
| Example 4a | 2-2a | 6.9 | 25.8 | 93 |
| Comparative Example 2a | 3-0a | 7.4 | 16.3 | 51 |
| Example 5a | 3-1a | 7.2 | 26.9 | 86 |
| Example 6a | 3-2a | 7.1 | 25.4 | 76 |
| Example 7a | 4-1a | 7.3 | 26.2 | 132 |
| Example 8a | 4-2a | 7.2 | 25.8 | 109 |
| Comparative Example 3a | 5-0a | 7.6 | 16.3 | 29 |
| Example 9a | 5-1a | 7.4 | 29.3 | 85 |
| Example 10a | 6-1a | 7.3 | 30.0 | 71 |
| Comparative Example 4a | 7-0a | 8.2 | 12.1 | 15 |
| Example 11a | 7-1a | 7.9 | 26.1 | 81 |
| Example 12a | 8-1a | 7.4 | 27.8 | 76 |
| Comparative Example 5a | 9-0a | 7.4 | 15.9 | 32 |
| Example 13a | 9-1a | 7.3 | 24.7 | 108 |
| Example 14a | 10-1a | 7.3 | 24.2 | 83 |
| Comparative Example 6a | 11-0a | 7.2 | 17.1 | 29 |
| Example 15a | 11-1a | 7.1 | 24.1 | 99 |
| Example 16a | 12-1a | 7.1 | 23.8 | 84 |
| Comparative Example 7a | 13-0a | 6.6 | 15.5 | 56 |
| Example 17a | 13-1a | 6.4 | 22.1 | 113 |
| Example 18a | 14-1a | 6.4 | 21.3 | 122 |
| Comparative Example 8a | 15-0a | 6.6 | 14.9 | 64 |
| Example 19a | 15-1a | 6.5 | 19.9 | 162 |
| Example 20a | 16-1a | 6.4 | 22.1 | 127 |
| Comparative Example 9a | 17-0a | 6.9 | 13.3 | 53 |
| Example 21a | 17-1a | 6.8 | 22.5 | 156 |
| Example 22a | 18-1a | 6.7 | 21.8 | 133 |
| Comparative Example 10a | 19-0a | 6.5 | 14.3 | 60 |
| Example 23a | 19-1a | 6.4 | 21.6 | 142 |
| Example 24a | 20-1a | 6.4 | 23.9 | 122 |
| Comparative Example 11a | 21-0a | 8.2 | 19.8 | 43 |
| Example 25a | 21-1a | 8.1 | 29.3 | 87 |
| Example 26a | 22-1a | 7.9 | 29.8 | 73 |
| Comparative Example 12a | 23-0a | 8.3 | 17.7 | 41 |
| Example 27a | 23-1a | 8.2 | 29.2 | 100 |
| Example 28a | 24-1a | 8.0 | 29.9 | 98 |
| Comparative Example 13a | 25-0a | 7.7 | 18.0 | 52 |
| Example 29a | 25-1a | 7.6 | 26.3 | 121 |
| Example 30a | 26-1a | 7.6 | 26.1 | 132 |
| Comparative Example 14a | 27-0a | 7.8 | 17.9 | 61 |
| Example 31a | 27-1a | 7.6 | 26.5 | 136 |
| Example 32a | 28-1a | 7.7 | 26.9 | 120 |

### REFERENCE SIGN LIST

- 1:: Light-emitting layer
- 2:: Anode
- 3:: Hole injection layer
- 4:: Cathode
- 5:: Electron injection layer
- 6:: Hole transport layer
- 7:: Electron transport layer
- 8:: Substrate

## Claims

1. An organic electronic material comprising a charge transport polymer including at least one structure selected from the group consisting of a structure represented by the following formula (1), a structure represented by the following formula (2), and a structure represented by the following formula (3): 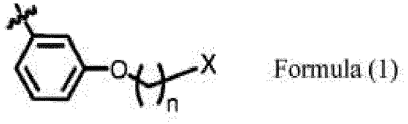 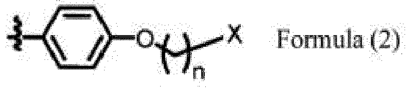 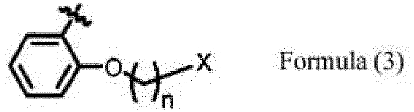 wherein in formulas (1) to (3), X represents a polymerizable functional group selected from the group consisting of a substituted or unsubstituted oxetane group and a substituted or unsubstituted vinyl group, and n represents an integer of 1 to 12.

2. The organic electronic material according to Claim 1, wherein the charge transport polymer has at least one structure selected from the group consisting of a structure represented by the (1), a structure represented by the formula (2) and a structure represented by the formula (3) at a terminal.

3. An organic electronic material comprising a charge transport polymer including at least one structure selected from the group consisting of a structure represented by the following formula (1a), a structure represented by the following formula (2a), and a structure represented by the following formula (3a): 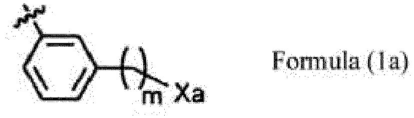 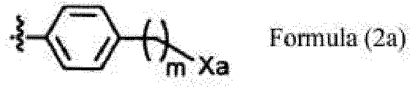 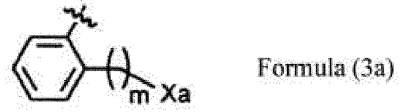 wherein in formulas (1a) to (3a), Xa represents a polymerizable functional group, and m represents an integer of 1 to 30.

4. The organic electronic material according to Claim 3, wherein the charge transport polymer has at least one structure selected from the group consisting of a structure represented by the formula (1a), a structure represented by the formula (2a) and a structure represented by the formula (3a) at a terminal.

5. The organic electronic material according to any one of Claims 1 to 4, wherein the charge transport polymer has a structure that branches in three or more directions, and includes a trivalent or higher valent structural unit containing a structure selected from the group consisting of a substituted or unsubstituted aromatic amine structure, a substituted or unsubstituted carbazole structure, a substituted or unsubstituted thiophene structure, a substituted or unsubstituted bithiophene structure, a substituted or unsubstituted benzene structure, a substituted or unsubstituted polycyclic aromatic structure in which a plurality of benzene rings are condensed, and a substituted or unsubstituted fluorene structure.

6. The organic electronic material according to any one of Claims 1 to 5, wherein the charge transport polymer includes a divalent structural unit containing a structure selected from the group consisting of a substituted or unsubstituted aromatic amine structure, a substituted or unsubstituted carbazole structure, a substituted or unsubstituted thiophene structure, a substituted or unsubstituted bithiophene structure, a substituted or unsubstituted benzene structure, a substituted or unsubstituted polycyclic aromatic structure in which a plurality of benzene rings are condensed, and a substituted or unsubstituted fluorene structure.

7. The organic electronic material according to any one of Claims 1 to 6, wherein the charge transport polymer is a hole transport material.

8. The organic electronic material according to any one of Claims 1 to 7, further comprising a polymerization initiator.

9. The organic electronic material according to Claim 8, wherein the polymerization initiator comprises a cationic polymerization initiator.

10. The organic electronic material according to Claim 9, wherein the cationic polymerization initiator comprises an onium salt.

11. An organic layer formed using the organic electronic material according to any one of Claims 1 to 10.

12. An organic electronic element comprising the organic layer according to Claim 11.

13. An organic electroluminescent element comprising the organic layer according to Claim 11.

14. The organic electroluminescent element according to Claim 13, comprising a light-emitting layer comprising a phosphorescent material.

15. The organic electroluminescent element according to Claim 13, comprising a light-emitting layer comprising a delayed fluorescent material.

16. The organic electroluminescent element according to any one of Claims 13 to 15, further comprising a flexible substrate.

17. The organic electroluminescent element according to any one of Claims 13 to 15, further comprising a resin film substrate.

18. A display element comprising the organic electroluminescent element according to any one of Claims 13 to 17.

19. An illumination device comprising the organic electroluminescent element according to any one of Claims 13 to 17.

20. A display device comprising the illumination device according to Claim 19, and a liquid crystal element as a display unit.
